# EUROPÄISCHE PATENTSCHRIFT

(11) **EP 2 867 318 B1**
(45) Veröffentlichungstag und Bekanntmachung des Hinweises auf die Patenterteilung: **12.01.2022**
(21) Anmeldenummer: 13727834.7
(22) Anmeldetag: 27.05.2013
(51) Int. Cl.: C09J 11/04, C09J 7/10, C09J 7/20, C09J 7/35, C09J 7/38, H01L 51/00, H01L 51/52

(54) **KLEBEBAND FÜR DIE KAPSELUNG EINER ORGANISCHEN ELEKTRONISCHEN ANORDNUNG**
ADHESIVE TAPE FOR ENCAPSULATING AN ORGANIC ELECTRONIC ASSEMBLY
BANDE ADHESIVE POUR L'ENCAPSULATION D'UN ENSEMBLE ELECTRONIQUE ORGANIQUE

(30) Priorität: 29.06.2012 DE 102012211335
(43) Veröffentlichungstag der Anmeldung: 06.05.2015
(73) Patentinhaber: tesa SE, 22848 Norderstedt (DE)
(72) Erfinder: BAI, Minyoung, 22529 Hamburg (DE); ELLINGER, Jan, 20255 Hamburg (DE); GRÜNAUER, Judith, 22117 Hamburg (DE); KEITE-TELGENBÜSCHER, Klaus, 22529 Hamburg (DE); PETERSEN, Anika, 24598 Heidmühlen (DE)
(74) Vertreter: tesa SE
(86) Internationale Anmeldenummer: PCT/EP2013/060895
(87) Internationale Veröffentlichungsnummer: WO 2014/001005

(56) Entgegenhaltungen:
- WO-A1-03/065470
- WO-A1-2011/018356
- WO-A2-2012/070871
- Anonymous: "Lithiumaluminiumhydrid", , 1 December 2007 (2007-12-01), pages 1-3, XP055664368, Retrieved from the Internet: URL:https://roempp.thieme.de/lexicon/RD-12 -01348#/ [retrieved on 2020-02-03]

## Beschreibung

Die vorliegende Erfindung betrifft ein Klebeband für die Kapselung einer organischen elektronischen Anordnung und ein Verfahren für dessen Anwendung.

### Stand der Technik:

Optoelektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen davon. Die entsprechenden Produkte sind je nach gewünschter Anwendung starr oder flexibel ausgebildet, wobei eine zunehmende Nachfrage nach flexiblen Anordnungen besteht. Die Herstellung derartiger Anordnungen erfolgt häufig durch Druckverfahren wie Hochdruck, Tiefdruck, Siebdruck, Flachdruck oder auch so genanntes "non impact printing" wie etwa Thermotransferdruck, Tintenstrahldruck oder Digitaldruck. Vielfach werden aber auch Vakuumverfahren wie beispielsweise Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet. Die Strukturierung erfolgt in der Regel durch Masken.

Als Beispiele für bereits kommerziell erhältliche oder in ihrem Marktpotential interessante optoelektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, ferner Elektrolumineszenzlampen, Licht emittierende elektrochemische Zellen (LEECs), organische Solarzellen wie Farbstoff- oder Polymersolarzellen, anorganische Dünnschichtsolarzellen, zum Beispiel auf der Basis von Silizium, Germanium, Kupfer, Indium und Selen, organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Demgemäß wird in dieser Schrift unter einer organischen elektronischen Anordnung eine elektronische Anordnung verstanden, die zumindest einen elektronisch funktionalen, zumindest teilweise organischen Bestandteil umfasst - z.B. metallorganische Verbindungen - oder deren elektronisch funktionaler Aufbau eine Dicke von weniger als 20 µm aufweist.

Damit sind unter diesem Begriff auch z.B. anorganische Dünnschichtsolarzellen und anorganische elektrochrome Schichtaufbauten umfasst. Auch dickere elektrolumineszierende Aufbauten mit anorganischen Partikeln sind umfasst, sofern organische, z.B. polymere, Schichten oder Matrixmaterialien zur Einbettung der Partikel verwendet werden, da hier die organischen Materialien als Dielektrikum eine elektronische Funktion übernehmen.

Unter elektronisch funktionalen Bestandteilen sind demgemäß zumindest aber nicht ausschließlich alle in einem elektronischen Aufbau zwischen den Kontaktelektroden (z.B. Anode und Kathode) und ggf. verwendeten weiteren elektrisch leitfähigen Schichten liegenden Materialien zu verstehen.

Nicht umfasst vom Begriff der organischen elektronischen Anordnung sind demgemäß klassische, auf Halbleiterwafern basierende elektronische Anordnungen, da deren Aufbau in der Regel dicker als 20 µm ist.

Synonym verwendet werden in dieser Schrift auch verkürzte Begriffe wie "elektronische Anordnung" oder "elektronischer Aufbau", sofern sich nicht aus dem Zusammenhang eine andere Bedeutung erschließt.

Als technische Herausforderung für die Realisierung einer ausreichenden Lebensdauer und Funktion von optoelektronischen Anordnungen auf dem Gebiet der anorganischen und organischen Optoelektronik, ganz besonders der organischen Optoelektronik, ist ein Schutz der darin enthaltenen Komponenten vor Permeaten zu sehen. Als Permeate werden dabei in der Regel gasförmige oder flüssige Stoffe angesehen, die in einen Festkörper eindringen und diesen gegebenenfalls durchdringen beziehungsweise durchwandern. Dementsprechend können viele niedermolekulare organische oder anorganische Verbindungen Permeate sein, wobei im vorliegend beschriebenen Zusammenhang Wasserdampf und Sauerstoff von besonderer Bedeutung sind.

Eine Vielzahl von optoelektronischen Anordnungen - besonders bei Verwendung von organischen Materialien - ist sowohl gegen Wasserdampf als auch gegen Sauerstoff empfindlich. Während der Lebensdauer der elektronischen Anordnungen ist deshalb ein Schutz durch eine Verkapselung erforderlich, da andernfalls die Leistung über den Anwendungszeitraum nachlässt. Anderenfalls können sich beispielsweise durch eine Oxidation der Bestandteile von Licht emittierenden Anordnungen wie ElektrolumineszenzLampen (EL-Lampen) oder organischen Leuchtdioden (OLED) die Leuchtkraft, bei elektrophoretischen Displays (EP-Displays) der Kontrast oder bei Solarzellen die Effizienz innerhalb kurzer Zeit drastisch verringern.

Auf dem Gebiet der anorganischen und insbesondere der organischen Optoelektronik gibt es daher einen hohen Bedarf für flexible Klebelösungen, die eine Barriere für Permeate wie Sauerstoff und/oder Wasserdampf darstellen. Im Stand der Technik sind bereits einige Ansätze für derartige Klebelösungen zu finden.

Durch eine Abdeckung, die für permeationsfähige Substanzen undurchlässig ist, können diese von der elektronischen Anordnung ferngehalten werden. Diese Abdeckung wird üblicherweise auf der elektronischen Anordnung und/oder auf den der elektronischen Anordnung angrenzenden Bereichen des Substrates, auf dem die Anordnung vorliegt, verklebt.

Für permeationsfähige Substanzen undurchlässige Abdeckungen können beispielweise vorliegen in Form einer undurchlässigen Schicht einer Klebemasse, die ggf. nachzubehandeln, zu stabilisieren oder ihrerseits abzudecken ist, oder in Form einer undurchlässigen Schicht eines starren oder flexiblen Materials, die vollflächig oder zumindest in den Randbereichen verklebt wird und so die elektronische Anordnung verkapselt.

Zur Ausbildung einer Klebeschicht und zur Verklebung von Abdeckmaterialien werden häufiger Flüssigklebstoffe und Adhäsive auf Basis von Epoxiden als Barriereklebemassen verwendet, wie sie beispielsweise in WO 98/21287 A1, US 4,051,195 A und US 4,552,604 A beschrieben sind. Ihr Haupteinsatzgebiet sind Randverklebungen starrer Anordnungen, aber auch mäßig flexible Anordnungen. Die Aushärtung erfolgt thermisch oder mittels UV-Strahlung.

Der Einsatz dieser flüssigen Klebstoffe bringt allerdings auch eine Reihe von unerwünschten Effekten mit sich. So können niedermolekulare Bestandteile (VOCs - volatile organic compounds) die empfindlichen elektronischen Strukturen der Anordnung schädigen und die Produktion erschweren. Der Klebstoff muss darüber hinaus aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess. Im anschließend erforderlichen Laminationsschritt kann aufgrund der geringen Viskosität das Erreichen einer definierten Schichtdicke und Verklebungsbreite erschwert sein.

Eine Alternative ist der Einsatz von Haft- oder Heißschmelzklebern zur Versiegelung von optoelektronischen Aufbauten. Unter den Haftklebemassen werden dabei bevorzugt solche eingesetzt, die nach der Verklebung durch eingebrachte Energie (zum Beispiel aktinische Strahlung oder Wärme) vernetzbar sind. Derartige Massen werden beispielsweise in US 2006/0100299 A1 und WO 2007/087281 A1 beschrieben. Ihr Vorteil liegt insbesondere darin, dass durch die Vernetzung die Barrierewirkung der Klebemassen verbessert werden kann.

Ebenso ist die Verwendung von Heißschmelzklebemassen im Stand der Technik bekannt. Vielfach werden hier Copolymere des Ethylens eingesetzt, zum Beispiel Ethylen-Ethylacetat (EEA), Ethylen-Acrylsäure-Copolymer (EAA), Ethylen-Butylacrylat (EBA) oder Ethylen-Methylacrylat (EMA). Insbesondere für auf Siliziumwafern basierende Solarzellenmodule werden in der Regel vernetzende Ethylen-Vinylacetat-(EVA)-Copolymere eingesetzt. Die Vernetzung findet während des Versiegelungsprozesses unter Druck und bei Temperaturen oberhalb von etwa 120 C statt. Dieser Prozess ist für viele auf organischen Halbleitern basierende oder in Dünnschichtverfahren hergestellte optoelektronische Aufbauten aufgrund der hohen Temperaturen und der mechanischen Belastung durch den Druck nachteilig.

Heißschmelzklebemassen auf der Basis von Blockcopolymeren oder funktionalisierten Polymeren sind beispielsweise in WO 2008/036707 A2, WO 2003/002684 A1, JP 2005-298703 A und US 2004/0216778 A1 beschrieben. Ein Vorteil dieser Klebemassen ist, dass durch die Klebstoffe selbst keine oder nur sehr wenig Substanz in den zu verkapselnden Aufbau eingebracht wird, die den Aufbau selbst schädigt, wohingegen dieses Problem vor allem bei reaktiven Flüssigklebersystemen, insbesondere solchen auf Acrylat- oder Epoxidharzbasis, relevant ist. Aufgrund der hohen Anzahl reaktiver Gruppen weisen diese Systeme eine relativ hohe Polarität auf, so dass insbesondere Wasser darin enthalten ist. Die Menge liegt in der Regel im Bereich von weniger als 100 ppm bis hin zu mehr als 1 %. Unter anderem auch aus diesem Grund werden solche Flüssigkleber - wie schon vorstehend erwähnt - vornehmlich als Randversiegelung der elektronischen Anordnungen eingesetzt, wobei sie nicht in direktem Kontakt mit den aktiven elektronischen Materialien stehen.

Handelsübliche Klebebänder sind ebenfalls üblicherweise für Permeate mehr oder weniger stark durchgängig, daher müssen die Klebebänder mit einer Barrierefunktion für eben diese Permeate versehen werden. Eine weitere Maßnahme ist daher die Ausstattung des Klebstoffs und/oder des Substrats und/oder der Abdeckung des elektronischen Aufbaus mit solchen permeat-bindenden Eigenschaften, also insbesondere mit solchen Substanzen, die in der Lage sind, die Permenaten zu sorbieren und somit nicht zur elektronischen Anordnung vorzulassen. Solche zur Sorption permeationsfähiger Substanzen befähigten Materialien werden als Gettermaterialien oder auch kurz als Getter bezeichnet. Nachteilig an der Ausstattung des Klebstoffs mit bindenden Eigenschaften ist die Beeinträchtigung der Klebeigenschaften durch das Gettermaterial. Insbesondere wenn dieses partikulär im Klebstoff vorliegt, nimmt es an der Kontaktfläche zum Verklebungsuntergrund Fläche ein, die nicht mehr zur Verklebung zur Verfügung steht. Weiterhin ist das Gettermaterial bei einer voll- oder teilflächigen Überdeckung der elektronischen Anordnung mit dieser in direktem Kontakt und kann sie aufgrund seiner Reaktivität schädigen. Der Effekt, dass die Gettermaterialien ihrerseits die Klebemassen selbst, aber auch die elektronische Anordnung mit der Zeit angreifen können, bedingt, dass die Anwesenheit von Gettermaterialien die Alterung von Haftklebemassen fördert und zur Verringerung der Lebensdauer der elektronischen Anordnung, zu deren Schutz sie eigentlich gedacht sind, führt, wenn dies auch nicht in dem Maße geschieht, wie dies durch die Permeate der Fall wäre. Der Zusatz von Gettermaterialien zu Klebemassen führt in der Regel außerdem sofort zu einer Absenkung der Klebkräfte, wie dies regelmäßig bei Zugabe höherer Mengen an Additiven festzustellen ist.

Im Stand der Technik, so in der WO2003065470 A1, wird gelehrt, dass die Menge des in eine Klebemasse eingebrachten Gettermaterials so hoch wie möglich sein sollte, ohne die Klebeigenschaften unzulässig stark zu beeinträchtigen. Hier wird ein Gehalt im Bereich von 5 - 95 Gew.-% für geeignet gehalten, bevorzugt 15 - 50 Gew.-%. Die EP 1 021 070 A1 lehrt, dass ein Gettergehalt von weniger als 5 % als unzureichend betrachtet werden muss.

Ferner ist es möglich, besonders permeatarme Rohstoffe einzusetzen oder den Klebstoff bei der Herstellung oder vor der Applikation von permeierenden Substanzen zu befreien, zum Beispiel durch thermische Trocknung, Vakuumtrocknung, Gefriertrocknung oder das Einmischen von Gettern. Nachteilig an derartigen Verfahren sind die lange Trockendauer und die gegebenenfalls hohen oder niedrigen Trocknungstemperaturen, die den Klebstoff schädigen oder chemische Reaktionen, wie zum Beispiel eine Vernetzung, auslösen können. Auch ist der Prozess des Einmischens und späteren Abtrennens der Getter aufwändig.

Weiterhin sind Heißschmelz- oder Haftklebemassen verfügbar, die inhärent keine oder nur eine sehr geringe Permeatdurchlässigkeit aufweisen. Um insbesondere die Sauerstoffpermeation gering zu halten, ist es oft notwendig, diese Haftklebemassen stark zu vernetzen. Aufgrund der dann notwendigen hohen Anzahl reaktiver Gruppen weisen diese Systeme wie die Flüssigkleber eine relativ hohe Polarität auf, so dass insbesondere Wasser darin enthalten ist. Die Menge liegt in der Regel im Bereich von weniger als 100 ppm bis hin zu mehr als 1 %. Somit führt ein Kontakt solcher Klebemassen mit dem elektronischen Aufbau zu einer sofortigen Schädigung, so dass eine Überdeckung des elektronischen Aufbaus, also eine im wesentlichen vollflächige Überlamination, nicht ohne Weiteres möglich ist. Solche Klebemassen können also nur für eine Randverkapselung eingesetzt werden oder müssen aufwändig getrocknet werden.

Die WO 03/065470 A1 offenbart organische elektronische Vorrichtungen, die zumindest teilweise durch mit Adsorptionsmaterial beladene Transferklebstoffe verkapselt sind. Das Adsorptionsmaterial kann ein Trockenmittel und/oder ein Gettermaterial sein. Der mit Adsorptionsmaterial beladene Transferklebstoff kann eine Dichtung um den Umfang der Vorrichtung bilden oder kann die gesamte Vorrichtung und ihren Umfang bedecken. Ein verkapselnder Deckel bedeckt das Gerät.

WO 2011/018356 A1 betrifft ein Verfahren zur Kapselung einer elektronischen Anordnung gegen Permeanten, bei dem eine zumindest teilweise vernetzte Haftklebmasse auf Basis von säureoder säureanhydridmodifizierten Vinylaromatenblockcopolymeren bereitgestellt wird und bei dem die Haftklebemasse auf und/oder um die zu kapselnden Bereiche der elektronischen Anordnung appliziert wird.
WO 2012/070871 A2 betrifft eine Klebstoffzusammensetzung zur Verwendung beim Verkapseln einer organischen elektronischen Vorrichtung, einen Klebefilm, ein Verfahren zur Herstellung eines Klebefilms und eine organische elektronische Vorrichtung. Die Klebstoffzusammensetzung kann zu einer Verkapselungsschicht mit hervorragender Haftung, Schlagzähigkeit, Wärmeableitung und Feuchtigkeitsbarriereeigenschaften geformt werden, und daher kann die organische elektronische Vorrichtung, die ein durch die oben genannte Klebstoffzusammensetzung verkapseltes Element umfasst, eine verlängerte Lebensdauer aufweisen und eine überlegene Haltbarkeit aufweisen.

Es besteht somit ein anhaltender Bedarf an einer Lösung, die eine organische elektronische Anordnung zuverlässig vor dem Einfluss von Permeaten schützt.

Aufgabe der Erfindung ist es daher, eine Klebemasse anzubieten, die zur Reduzierung der Nachteile des Standes der Technik beitragen kann, die insbesondere eine längere Lebensdauer einer organischen elektronischen Anordnung zulässt als solche Klebemassen, die nach dem Stand der Technik für die Verklebung von Abdeckungen zum Schutz elektronischer Anordnungen eingesetzt werden, und die weiterhin insbesondere lange abdichtende Wirkung im genannten Einsatzgebiet besitzen. Vorteilhaft sollten die - insbesondere klebtechnischen - Eigenschaften des Klebebandes durch eine entsprechende Modifikation der Klebemasse nicht nachteilig verändert werden, und weiter vorteilhaft sollte keine wesentliche Veränderung dieser Eigenschaften über die Anwendungsdauer des Klebebandes hinweg festzustellen sein.

Die Aufgabe konnte gelöst werden, indem die Verkapselung der empfindlichen, auf einem Substrat befindlichen organischen elektronischen Anordnung mittels einer Abdeckung geschieht, die mittels eines- insbesondere weitgehend permeatfreien - Klebebandes fixiert wird, umfassend zumindest eine Schicht einer Klebmasse, die
- an sich inhärent eine sehr geringe Permeatdurchlässigkeit aufweist,
- und ein Gettermaterial in geringen Anteilen umfasst.

Dementsprechend betrifft der Hauptanspruch ein Verfahren zum Schutz einer auf einem Substrat angeordneten organischen elektrischen Anordnung, wobei eine Abdeckung derart auf die elektronische Anordnung aufgebracht wird, dass die elektronische Anordnung zumindest teilweise durch die Abdeckung überdeckt wird, wobei weiterhin die Abdeckung zumindest teilflächig auf dem Substrat und/oder auf der elektronischen Anordnung verklebt wird, wobei die Verklebung mittels zumindest einer Schicht einer Klebemasse bewirkt wird. Die Klebemassenschicht liegt dabei insbesondere als Schicht eines Klebebandes vor. Das Verfahren ist erfindungsgemäß dadurch gekennzeichnet, dass
eine Klebemasse eingesetzt wird, die, ausgeformt zur Schicht mit einer Dicke von 50 µm, eine Wasserdampfpermetationsrate von weniger als 50 g/m2d aufweist, wie bei 38 °C und 90 % relativer Luftfeuchtigkeit nach ASTM F-1249 gemessen,
die Klebemasse einen Permeatgehalt von weniger als 1000 ppm wie nach DIN 53715 nach Lagerung über 24 Stunden bei 23 °C und 50 % relativer Luftfeuchte bestimmt enthält, bezogen auf die Relation des enthaltenen Gesamtgewichts an Permeat zum Klebemassengewicht, wobei das Permeat Wasser ist, und
die Klebemasse ein zur Sorption von Wasser befähigtes Gettermaterial umfasst, wobei das Gettermaterial ausgewählt ist aus Calciumoxid, Calciumsulfat, Calciumchlorid und Zeolithen sowie aus Mischungen von zwei oder mehreren der vorstehenden Substanzen,
und wobei das Gettermaterial zu einem Anteil von nicht mehr als 2 Gew.-% und mindestens 0,5 Gew.-%, jeweils bezogen auf die Klebemasse mit dem Gettermaterial, in der Klebemasse vorliegt. Insbesondere wurde eine solche Klebemasse eingesetzt, die bereits inhärent eine geringe Permeatdurchlässigkeit besitzt (im folgenden als Klebemasse mit inhärenter Barrierewirkung bezeichnet). Besonders bevorzugt weist die Klebemasse bei einer Dicke von 50 µm eine Sauerstoffdurchtrittsrate von weniger als 5000 g/(m²·d·bar) auf.

Die Unteransprüche betreffen vorteilhafte Verfahrensführungen.

Gegenstand der Erfindung ist zudem ein Klebeband, umfassend eine Schicht einer Klebemasse, wobei die Klebemasse ein zur Sorption von Wasser befähigtes Gettermaterial umfasst, wobei das Gettermaterial ausgewählt ist aus Calciumoxid, Calciumsulfat, Calciumchlorid und Zeolithen sowie aus Mischungen von zwei oder mehreren der vorstehenden Substanzen, wobei
die Klebemasse, wenn ausgeformt zur Schicht mit einer Dicke von 50 µm, eine Wasserdampfpermetationsrate von weniger als 50 g/m²d aufweist, wie bei 38 °C und 90 % relativer Luftfeuchtigkeit nach ASTM F-1249 gemessen,
die Klebemasse einen Permeatgehalt von weniger als 1000 ppm wie nach DIN 53715 nach Lagerung über 24 Stunden bei 23 °C und 50 % relativer Luftfeuchte bestimmt enthält, bezogen auf die Relation des enthaltenen Gesamtgewichts an Permeaten zum Klebemassengewicht, wobei das Permeat Wasser ist, und
das Gettermaterial zu einem Anteil von nicht mehr als 2 Gew.-% und mindestens 0,5 Gew.-%, jeweils bezogen auf die Klebemasse mit dem Gettermaterial, in der Klebemasse vorliegt.

Sehr vorteilhaft ist die Klebemasse des erfindungsgemäßen Klebebandes und die Klebemasse des im erfindungsgemäßen Verfahren eingesetzten Klebebandes eine Haftklebemasse, in einer weiteren bevorzugten Ausführungsvariante eine aktivierbare Klebemasse. Besonders bevorzugt werden aktivierbare Haftklebemassen eingesetzt.
Als Haftklebemassen werden Klebemassen bezeichnet, deren abgebundener Film bei Raumtemperatur in trockenem Zustand permanent klebrig und klebfähig bleibt. Haftklebemassen erlauben bereits unter relativ schwachem Andruck eine dauerhafte Verbindung mit dem Haftgrund und können nach Gebrauch im Wesentlichen rückstandsfrei vom Haftgrund wieder abgelöst werden. Die Verklebbarkeit der Klebemassen beruht auf ihren adhäsiven Eigenschaften und die Wiederablösbarkeit auf ihren kohäsiven Eigenschaften.
Als aktivierbare Klebemassen werden Klebemassensysteme angesehen, bei denen die Verklebung durch einen Energieeintrag, zum Beispiel durch aktinische Strahlung oder Wärme, erfolgt.

Im Folgenden wird die Bezeichnung "(Haft-)Klebemasse" im Sinne von "Klebemasse, insbesondere in der Ausführungsform als Haftklebemasse" verwendet. Entsprechend bedeutet die Bezeichnung "(Haft-)Klebeband" "Klebeband, insbesondere in der Ausführung als Haftklebeband". Ohne Weiteres sollen die jeweils aktivierbaren Varianten explizit mit umfasst sein. Sofern lediglich von "Klebemasse" oder "Klebeband" die Rede ist, soll die Ausführungsform als "Haftklebeband" bzw. "Haftklebemasse" und die Ausführungsform als aktivierbare Klebemasse, auch in Kombination miteinander (aktivierbare Haftklebemasse), jedoch explizit umfasst sein, sofern im Einzelnen nichts anderes angegeben ist.

Überraschend zeigte sich, dass die (Haft-)Klebemassen mit einem geringen Gettermaterialanteil zu höhere Lebensdauern der organischen elektronischen ASnordnungen auf denen sie verklebt sind, führen, als diese für (Haft-)Klebemassen mit einem Gettermaterialanteil nach dem Stand der Technik bekannt sind. Der Fachmann hätte dementgegen erwartet, dass höhere Gettermaterialenteile zu einer Verlängerung der Lebensdauer der organischen elektronischen Anordnung führen sollten, da ein erhöhter Gettermaterialanteil stärker vor einpemeierenden Schadsubstanzen schützt.
In Folge des erhaltenen Ergebnisses wird angenommen, dass das Gettermaterial selbst einen Beitrag zum Abbau der organischen Elektronik leistet und / oder Permeationswege in den elektronischen Aufbau öffnet.

Das erfindungsgemäße Verfahren weist somit eine Trennung bezüglich der Funktionen auf, die im Stand der Technik durch Gettermaterialien in hohen Mengen realisiert werden: Durch die inhärente Barrierewirkung wird gewährleistet, dass Permeate die Verkapselung nicht durchdringen können. Durch den Getteranteil wird gewährleistet, dass im Aufbau der organischen elektronischen Anordnung bereits befindliche Permeate - die etwa produktionsbedingt oder lagerbedingt vor der Verkapselung anwesend sind - abgefangen werden. Gleichfalls werden solche Permeate abgefangen, die während der Herstellung, der Konfektionierung und/oder der Lagerung des (Haft-)Klebebandes in dieses eindringen bzw. in dieses bereits eingedrungen sind. Während Herstellung und Lagerung des (Haft)Klebebandes wird dieses somit weitgehend von Permeaten freigehalten.
Die Funktionstrennung bewirkt, dass die Nachteile des Standes der Technik überwunden werden können.

Vorteilhaft beträgt der Anteil des Gettermaterials in der (Haft-)Klebemasse nicht mehr als 1 Gew.-%.

In bevorzugter Vorgehensweise wird ein Klebeband, insbesondere ein Haftklebeband, eingesetzt, das in Form einer einzigen Schicht der entsprechenden (Haft-)Klebemasse eingesetzt wird. Solche einschichtigen Klebebänder werden als "Transferklebebänder" bezeichnet und zur leichteren Handhabbarkeit häufig ein- oder doppelseitig mit einem temporären Träger angeboten, der für die Anwendung wieder entfernt wird. Als temporäre Träger sind beispielweise antiadhäsive Folien und Papiere geeignet, etwa silikonisierte Folien und Papiere.

Das erfindungsgemäße Verfahren kann vorteilhaft derart geführt werden, dass zunächst die (Haft-)Klebemassenschicht, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird. In einer weitere vorteilhaften Vorgehensweise werden die (Haft-)Klebemassenschicht, gegebenenfalls als Bestandteil eines weitere Schichten umfassenden doppelseitig klebenden Klebebandes, und die Abdeckung gemeinsam auf das Substrat und/oder die elektronische Anordnung aufgebracht.
Beim erfindungsgemäßen Verfahren kann das Transferklebeband somit zunächst mit dem Substrat bzw. der elektronischen Anordnung verbunden werden oder zuerst mit der Abdeckung. Bevorzugt ist jedoch, zunächst das Transferklebeband mit der Abdeckung zu verbinden, da somit eine Baugruppe der elektronischen Funktionseinheit unabhängig von der elektronischen Anordnung vorgefertigt und als Ganzes zulaminiert werden kann.

Vorteilhaft kann das erfindungsgemäße Verfahren derart geführt werden, dass die Abdeckung und/oder die (Haft-)Klebemassenschicht, insbesondere als Transferklebeband, die elektronische Anordnung vollständig überdecken.

Durch die vollflächige Lamination des Transferklebebands über die elektronische Anordnung wird zudem die Einwirkung möglicherweise im Gasraum einer lediglich randverkapsleten Anordnung eingeschlossener schädlicher Permeate ausgeschlossen, da es keinen Gasraum gibt. Im Wesentlichen durch die unerwartet starke synergistische Wirkung von vollflächiger Lamination mit permeationssperrender Klebemasse und geringem Gettermaterialanteil wird die Aufgabe überraschend gelöst.

Das erfindungsgemäße Verfahren wird bevorzugt derart geführt, dass auch ein Bereich des Substrats um die elektronische Anordnung herum durch die Abdeckung ganz oder teilweise überdeckt wird, wobei das Klebeband zur Verklebung die elektronische Anordnung dabei vollflächig bedecken kann - und bevorzugt ebenfalls einen Bereich des Substrats um die elektronische Anordnung herum bedeckt, bevorzugt denselben Bereich wie die Abdeckung - oder teilflächig aufgebracht sein kann, etwa rahmenförmig um die elektrische Anordnung herum - bevorzugt in dem Bereich, der auch durch die Abdeckung bedeckt wird -, und gegebenenfalls zusätzlich in einem Randbereich auf der elektronischen Anordnung.

Das Gettermaterial kann dispergiert in der Klebemasseschicht vorliegen oder als Schicht innerhalb oder auf einer der Seiten der Klebemasseschicht. Bevorzugt liegt das Gettermaterial als dispergierte Phase in der Klebemasse vor.

Unter "als dispergierte Phase vorliegend" wird verstanden, dass das Gettermaterial fein verteilt in der Klebemasse vorliegt. Grundsätzlich sind Form und Größe der Gettermaterial-Teilchen - selbstverständlich innerhalb der sich aus dem Aufbau und der Funktion der Klebemasseschicht ergebenden Limitierungen - keine Grenzen gesetzt. Das Merkmal "als dispergierte Phase vorliegend" schließt eine molare Dispersion des Gettermaterials und damit eine echte (molekulare) Lösung des Gettermaterials in der Klebemasse ebenso ein wie eine Dispersion von Gettermaterial-Primärteilchen, Gettermaterial-Aggregaten und Gettermaterial-Agglomeraten. Die Getterteilchen können in ihrer Struktur kugelförmig, stäbchenförmig oder plättchenförmig vorliegen. Insbesondere plättchenförmige Materialien liegen bevorzugt im Wesentlichen vereinzelt und nicht als Plättchenstapel vor.

Das Merkmal "als dispergierte Phase vorliegend" bedeutet darüber hinaus, dass das Gettermaterial keine eigenständige, durchgehende Schicht bildet, sondern generell in Form mehrerer, verteilter Teilchen vorliegt. Es bedeutet hingegen nicht, dass eine ideale Verteilung der Gettermaterial-Teilchen in der Klebemasseschicht vorliegen muss, dies kann aber so sein. Die Gettermaterial-Teilchen können sich zum Beispiel aber durchaus in bestimmten Bereichen innerhalb der Schicht konzentrieren beziehungsweise können bestimmte Bereiche in der Klebemasseschicht auch frei von Gettermaterial sein.

Grundsätzlich ist die Größe der Partikel des Gettermaterials durch die Anforderungen der Dicke der diese enthaltenden Schicht, beispielsweise der Klebemasseschicht, begrenzt. Als eine obere Grenze für die Größe der Partikel können daher etwa 200 µm angesehen werden, bevorzugt wird aber Gettermaterial in Form von Teilchen mit einer Korngröße von maximal 50 µm, besonders bevorzugt in Form von Teilchen mit einer Korngöße von maximal 10 µm verwendet.

Vorzugsweise liegt das Gettermaterial in Form von Partikeln in einer Partikelgrößenverteilung vor, bei der maximal 1 Vol.-% des Gettermaterials die mittlere Schichtdicke der gettermaterialhaltigen Schicht überschreitet. Dies hat den Vorteil, dass die Getterpartikel nicht aus der jeweiligen Schicht herausragen und damit die Oberflächeneigenschaften stark negativ beeinflussen. In einer besonders bevorzugten Ausführungsform liegt das gesamte im erfindungsgemäßen Transferklebeband enthaltene Gettermaterial in einer Partikelgrößenverteilung vor, bei der maximal 1 Vol.-% des Gettermaterials die mittlere Schichtdicke der gettermaterialhaltigen Schicht überschreitet.

Unter "Partikeln" werden im Sinne von DIN 53206-1: 1972-08 Primärteilchen, Aggregate und Agglomerate des Gettermaterials beziehungsweise der Gettermaterialien verstanden. Unter der "Partikelgröße" wird die maximale Ausdehnung eines Partikels verstanden. Die Bestimmung der Partikelgröße erfolgt bevorzugt mittels Laserbeugung nach ISO 13320 (wobei im Dispersionsschritt Agglomerate dispergiert werden, nicht jedoch Aggregate) , aber auch andere dem Fachmann bekannte Verfahren sind geeignet.

Besonders bevorzugt liegen alle Gettermaterialien nanoskalig vor, das heißt die maximale Ausdehnung in mindestens einer Dimension beträgt weniger als 500 nm, ganz besonders bevorzugt weniger als 200 nm, beispielsweise weniger als 100 nm.

Solche Gettermaterialien können beispielsweise dispergiertes pyrogenes Silica wie Aerosil der Firma Evonik, Calcium Oxide Nanopowder der Firma Sigma-Aldrich, Calciumchlorid CA-CI-02-NP der Firma American Elements (Los Angeles), Nanozeolith LTA oder FAU der Firma Nanoscape (Planegg-Martinsried) oder nanoskaliges Zeolith Lucidot NCL 40 der Firma Clariant (Frankfurt) sein.

Weiterhin kann das Transferklebeband über die Klebemasseschicht und ggf. eine Gettermaterialschicht hinaus aus weiteren Schichten bestehen. Dies können z.B. weitere Klebemasseschichten, Trägermaterial oder Liner sein.

Bevorzugt ist eine solche weitere Schicht ein Trägermaterial, insbesondere ein polymeres Trägermaterial, da hierdurch die Stanzbarkeit oder Applizierbarkeit des Aufbaus verbessert wird..

Als Trägermaterial können textile Flächengebilde, Papiere, kunststoffbeschichtete Papiere oder Folien eingesetzt werden, wobei Folien, insbesondere dimensionsstabile Kunststoffoder Metallfolien, bevorzugt werden. Eine Trägerschicht besteht daher bevorzugt aus Polyestern, insbesondere aus Polyethylenterephthalat, zum Beispiel aus biaxial verstrecktem Polyethylenterephthalat, oder aus Polyolefinen, insbesondere aus Polybuten, Cyclo-Olefin-Copolymer, Polymethylpenten, Polypropylen oder Polyethylen, zum Beispiel aus monoaxial verstrecktem Polypropylen, biaxial verstrecktem Polypropylen oder biaxial verstrecktem Polyethylen. Polyesterfolien weisen den Vorteil auf, dass sie für Temperaturstabilität sorgen und eine erhöhte mechanische Stabilität einbringen. Ganz besonders bevorzugt besteht daher eine Trägerschicht in einem erfindungsgemäßen Liner aus einer Polyesterfolie, beispielsweise aus biaxial verstrecktem Polyethylenterephthalat.

In einer bevorzugten Ausführungsform enthält das Trägermaterial auch eine Barrierfunktion gegen ein oder mehrere spezifische(s) Permeat(e), insbesondere gegen Wasserdampf und Sauerstoff. Eine derartige Barrierefunktion kann aus organischen oder anorganischen Materialien bestehen. Trägermaterialien mit Barrierefunktion sind in EP 2 078 608 A1 ausführlich dargestellt.

Besonders bevorzugt enthält das Trägermaterial mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle, wie Aluminium, Silber, Gold, Nickel oder insbesondere Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Als besonders geeignetes Verfahren zum Aufbringen einer anorganischen Barriereschicht sind High-Power-Impulse-Magnetron-Sputtering und Atomic-Layer-Deposition zu nennen, durch die sich besonders permeationsdichte Schichten bei geringer Temperaturbelastung der Trägerschicht verwirklichen lassen. Bevorzugt wird eine Permeationsbarriere der Trägerschicht mit Barrierefunktion beziehungsweise des Verbundes aus Trägerschicht und Barriereschicht gegen Wasserdampf (WVTR) von < 1 g/(m²*d) und/oder gegen Sauerstoff (OTR) von < 1 cm³/(m²*d*bar), wobei der Wert auf die jeweils im Flächengebilde verwendete Dicke der Trägerschicht bezogen ist, also nicht auf eine spezifische Dicke normiert ist. Die WVTR wird dabei bei 38°C und 90% relativer Luftfeuchtigkeit nach ASTM F-1249 und die OTR bei 23°C und 50% relativer Luftfeuchtigkeit nach DIN 53380-Teil 3 gemessen.

Ist das Trägermaterial wie vorstehend beschrieben mit einer Barrierefunktion ausgerüstet, kann es auch als Abdeckung im erfindungsgemäßen Verfahren angesehen werden. In diesem Fall wird die Klebemasse zunächst auf die Abdeckung aufgebracht.

Klebebänder, die ein- oder beidseitig mit Klebstoffen beschichtet sind, werden am Ende des Herstellungsprozesses zumeist zu einer Rolle in Form einer archimedischen Spirale aufgewickelt. Um bei doppelseitig klebenden Klebebändern zu verhindern, dass die Klebemassen miteinander in Kontakt kommen, oder um bei einseitig klebenden Klebebändern eine Verklebung der Klebemasse auf dem Träger zu verhindern, werden die Klebebänder vor dem Wickeln mit einem Abdeckmaterial (auch als Trennmaterial bezeichnet) eingedeckt, das zusammen mit dem Klebeband aufgewickelt wird. Dem Fachmann sind derartige Abdeckmaterialien unter den Namen Liner oder Releaseliner bekannt. Neben der Abdeckung von ein- oder doppelseitig klebenden Klebebändern werden Liner auch zur Eindeckung von reinen Klebemassen (Transferklebeband) und Klebebandabschnitten (zum Beispiel Etiketten) eingesetzt.

Das erfindungsgemäße (Haft-)Klebeband und das für das erfindungsgemäße Verfahren eingesetzte (Haft-)Klebeband enthalten mindestens ein zur Sorption mindestens einer permeationsfähigen Substanz befähigtes Gettermaterial, wobei die permeationsfähige Substanz Wasser ist.

Unter "Sorption" wird der Vorgang der selektiven Aufnahme eines Stoffes oder mehrerer Stoffe durch einen anderen Stoff - erfindungsgemäß durch das Gettermaterial - verstanden. Die Sorption der permeationsfähigen Substanz(en) durch das Gettermaterial kann dabei beispielsweise durch Absorption oder Adsorption erfolgen, wobei Adsorption sowohl in Form von Chemisorption als auch von Physisorption auftreten kann.

Unter einer "permeationsfähigen Substanz" wird eine Substanz verstanden, die als gasförmiger oder flüssiger, gegebenenfalls auch als fester Stoff, in die zu schützende Klebemasse eindringen und diese nachfolgend durchdringen kann. Derartige Substanzen werden nachstehend - wie im vorliegenden Text schon mehrfach geschehen - als "Permeate" bezeichnet. Die Permeate können aus der Klebemasse selbst oder aus der Umgebung, beispielsweise auch aus dem Trägermaterial eines mit der Klebemasse beschichteten Klebebandes stammen. Aus der Klebemasse beziehungsweise aus dem Klebeband selbst kommen häufig niedermolekulare organische Verbindungen wie Lösemittelreste, Restmonomere, Öle, Harzkomponenten, Weichmacher sowie Wasser. Aus der Umgebung stammen oft Wasser, flüchtige organische Verbindungen (VOCs), niedermolekulare Kohlenwasserstoffe und Sauerstoff. Als "permeationsfähige Substanzen" werden insbesondere die folgenden Substanzen angesehen:
Acetonitril, 1-Butanol, Chlorbenzol, Chloroform (Trichlormethan), Cyclohexan, Diethylether, 1,4-Dioxan, Eisessig (Essigsäure), Essigsäureanhydrid, Essigsäureethylester (Ethylacetat, Essigester), Essigsäure-n Butylester (n-Butyl Acetat), Essigsäure-tert. butylester (t-Butyl Acetat), Ethanol, Methanol, n-Hexan, n-Heptan, 3-Hexanon, 2-Propanol (Isopropanol), 3-Methyl-1-butanol (Isoamylalkohol), Methylenchlorid (Dichlormethan), Methylethylketon (Butanon), Methylisobutylketon, Nitromethan (Nitrocarbol), n-Pentan, 2-Pentanon, 3-Pentanon, Petrolether (Leichtbenzin), Benzin, Propanol, Pyridin (Azin), tert-Butylmethylether, Tetrachlorethen (Perchlorethen), Tetrahydrofuran, Toluol, Trichlorethan, Triethylamin, Xylol, Sauerstoff, Methan, Ethan, Propan, Propen, Butan, Buten, Kohlenstoffdioxid, Ozon, Schwefeldioxid, Wasser.

Unter einem "Gettermaterial" wird ein Material verstanden, das - im Sinne des vorstehend als "Sorption" definierten Vorgangs - mindestens eine permeationsfähige Substanz selektiv oder nicht selektiv aufnehmen kann. Das Gettermaterial ließe sich daher auch als "Sorbens" oder als "Sorptionsmittel" bezeichnen. Gemäß der vorliegenden Erfindung ist das Gettermaterial mindestens zur Sorption von Wasser befähigt.

Die Gettermaterialien werden ihrer Funktion entsprechend bevorzugt als im Wesentlichen von Permeaten freie Materialien eingesetzt, zum Beispiel wasserfrei. Dies unterscheidet Gettermaterialien von ähnlichen Materialien, die als Füllstoff eingesetzt werden.

Das Gettermaterial ist ausgewählt aus Calciumoxid, Calciumsulfat, Calciumchlorid und Zeolithen sowie aus Mischungen von zwei oder mehreren der vorstehenden Substanzen. Diese Materialien weisen besonders hohe Kapazitäten für die Aufnahme von Wasser und weiteren Permeaten auf, sind größtenteils regenerierbar, lassen sich hervorragend in die Klebemasse einarbeiten und beeinträchtigen die Funktion dieser Schicht in der erfindungsgemäßen Menge gar nicht beziehungsweise nur in vernachlässigbarer Art und Weise.

Insbesondere ist das Gettermaterial Calciumoxid. Diese Substanz lässt über eine Änderung ihrer optischen Eigenschaften Rückschlüsse auf den Permeatgehalt der Klebemasse zu, indem sie beispielsweise mit zunehmender Wasseraufnahme eine Änderung von weiß zu einem transparenten Erscheinungsbild vollzieht. So lange also noch freie Getterkapazität anhand des optischen Erscheinungsbildes des Transferklebebands erkennbar ist, kann dies als Indiz dafür gelten, dass noch kein oder allenfalls wenig Permeat in die Klebemasse diffundiert ist.

In einer weiteren bevorzugten Ausführung bindet das Gettermaterial das Permeat durch Chemisorption. Dieser Prozess läuft aufgrund der in der Regel höhere Aktivierungsenergie langsamer ab als die Physisorption. Ein bekanntes Beispiel ist hier Calciumoxid, welches durch den Permeat Wasser in Calciumhydroxid umgewandelt wird. Durch die langsamere Umsetzung ergibt sich die Möglichkeit, das Gettermaterial kurzzeitig an Umgebungsatmosphäre handzuhaben, ohne dass bereits ein wesentlicher Teil der Aufnahmekapazität verloren geht.

Das Einbringen des Gettermaterials oder der Gettermaterialien in die Klebemasse kann durch sämtliche dem Fachmann bekannte Verfahren erfolgen. Dabei kann das Gettermaterial in Lösung, Dispersion, Schmelze oder als Fluid vorliegen.

Die Klebemasseschicht enthält erfindungsgemäß nicht mehr als 2 Gew.-% Gettermaterial.

Der Gehalt hängt wesentlich von der gewünschten Aufnahmekapazität für den/die jeweiligen Permeaten ab.

Wenn zum Beispiel nur eine geringe Aufnahmekapazität erforderlich ist, reicht gegebenenfalls die Verwendung eines Gettermaterials mit geringer Aufnahmekapazität in einem geringen Gehalt aus. Erfindungsgemäß enthält die Klebemasseschicht mindestens 0,5 Gew.-% Gettermaterial.

Bei einer sehr hohen erforderlichen Aufnahmekapazität der Klebemasseschicht muss jedoch ein relativ hoher Gehalt an Gettermaterial verwendet werden, wobei auch das Gettermaterial eine hohe Aufnahmekapazität besitzen sollte. Aber auch ein Gettermaterial mit geringer Aufnahmekapazität kann verwendet werden, wenn dies Kosten- oder Verträglichkeitsaspekte anraten. Im Rahmen einer weiteren bevorzugten Ausführungsform des erfindungsgemäßen Flächengebildes enthält dieses daher 0,5 bis 1,9 Gew.-%.

Es wird ein Gettermaterial mit hoher Aufnahmekapazität (maximal aufnehmbares Permeatgewicht > 25 % des Gettergewichts) bevorzugt, da hiermit der Gehalt an Getter gering gehalten werden kann. Die Aufnahmekapazität wird dabei nach Lagerung des Gettermaterials über 100 h bei 23 °C und 50 % relativer Luftfeuchte für das Permeat Wasserdampf oder bei 23 °C in gesättigter Atmosphäre bei anderen gasförmigen Permeaten ermittelt. Der Permeatgehalt des Getters nach Lagerung kann gravimetrisch bestimmt werden.

Bevorzugt ist das Transferklebeband transparent, das heißt die Transmission gemessen nach ASTM D1003-00 (Procedure A, in Abwandlung jedoch Normlichtart D65) ist größer als 50 %, bevorzugt größer als 75 %. Mit Transparenz kann das Flächengebilde in der Anwendung leichter positioniert werden und in Anwendungen, bei denen Transparenz erforderlich ist, z.B. lichtemittierende elektronische Aufbauten oder Solarzellen, für eine zumindest teilflächige, aber auch vollflächige Überklebung des elektronischen Aufbaus verwendet werden.

Besonders bevorzugt ist das Transferklebeband UV-Licht undurchlässig, das heißt die Transmission in einem Wellenlängenbereich von 300 bis 400 nm, gemessen nach ASTM D1003-00 (Procedure B, in Abwandlung jedoch Normlichtart D65), ist geringer als 25 %, bevorzugt geringer als 10 %. Mit einem UV-undurchlässigen Flächengebilde kann ein elektronischer Aufbau vor Veränderungen (zum Beispiel chemische Reaktionen, Alterung, Vernetzung) durch Beaufschlagung mit UV-Licht geschützt werden. Bevorzugt ist daher das Gettermaterial gleichzeitig ein UV-Absorber, da dann auf die zusätzliche Zugabe eines UV-Absorbers verzichtet werden kann.

Die Klebemasse ist bevorzugt eine Haftklebemasse oder eine aktivierbare Klebemasse und insbesondere eine aktivierbare Haftklebemasse.

Erfindungsgemäß besteht bezüglich der chemischen Natur der eingesetzten (Haft-)Klebemassen grundsätzlich keine Beschränkung. So können erfindungsgemäß beispielsweise Haftklebemassen auf der Basis von Acrylaten und/oder Methacrylaten, Polyurethanen, Naturkautschuken und/oder Silikonen ein gesetzt werden.

Werden im Rahmen dieser Schrift Haftklebemassen auf Acrylatbasis erwähnt, so seien hiervon auch ohne explizite Erwähnung Haftklebemassen auf Basis von Methacrylaten und auf Basis von Acrylaten und Methacrylaten umfasst, sofern nicht ausdrücklich anders beschrieben. Ebenfalls im Sinne der Erfindung sind Kombinationen und Mischungen mehrerer Basispolymere sowie mit Klebharzen, Füllstoffen, Alterungsschutzmitteln und Vernetzern additivierte Klebemassen einsetzbar, wobei die Aufzählung der Additive nur beispielhaft und nicht einschränkend zu verstehen ist.

Sehr bevorzugt werden Klebemassen verwendet, die wasserfrei gehalten werden können oder die aufgrund ihrer chemischen Natur dazu beitragen, dass der Wassergehalt so gering wie möglich gehalten werden kann. Dies lässt sich insbesondere erzielen durch die Verwendung von Haftklebemassen mit unpolaren Eigenschaften. Erfindungsgemäß sehr vorteilhaft werden daher Haftklebemassen auf Basis von Synthesekautschuken; Styrolblockcopolymermassen mit einem Elastomerblock aus ungesättigten oder hydrierten Polydienblöcken wie zum Beispiel Polybutadien, Polyisopren, Copolymere aus beiden sowie weitere, dem Fachmann geläufige Elastomerblöcke; Haftklebemassen auf Basis von Polyolefinen eingesetzt.
Sehr bevorzugt werden Haftklebstoffe auf der Basis von Styrolblockcopolymeren, Polybutylenen, Polyolefinen, da sich diese durch eine hohe Permeationsbarriere gegen Wasserdampf sowie einen geringen Gehalt an Wasser auszeichnen.

Hitzeaktiviert verklebende Klebemassen lassen sich grundsätzlich in zwei Kategorien einordnen: thermoplastische hitzeaktiviert verklebende Klebemassen (Schmelzklebstoffe) und reaktive hitzeaktiviert verklebende Klebemassen (Reaktivklebstoffe). Ebenfalls umfasst sind solche Klebemassen, die sich beiden Kategorien zuordnen lassen, nämlich reaktive thermoplastische hitzeaktiviert verklebende Klebemassen (reaktive Schmelzklebstoffe).

Thermoplastische Klebemassen basieren auf Polymeren, die bei einem Erwärmen reversibel erweichen und während des Erkaltens wieder erstarren. Als thermoplastische Klebemassen haben sich insbesondere solche auf der Basis von Polyolefinen und Copolymeren von Polyolefinen sowie von deren säuremodifizierten Derivaten, von lonomeren, von thermoplastischen Polyurethanen, von Polyamiden sowie Polyestern und deren Copolymeren und auch von Blockcopolymeren wie Styrol-Blockcopolymeren als vorteilhaft herausgestellt.
Auch hier werden erfindungsgemäß besonders bevorzugt die aktivierbaren Klebemassen ausgewählt, die unpolare Eigenschaften besitzen, da hierdurch der Wassergehalt gering gehalten werden kann und die Barierrewirkung gegen Wasserdampf gut ist. Insbesondere die Klebemassen auf Basis von Polyolefinen, auf Basis von Copolymeren von Polyolefinen sowie deren säuremodifizierten Derivaten, auf Basis von Polyamiden, auf Basis von Polyamid-Copolymeren und auf Basis von Blockcopolymeren wie StyrolBlockcopolymeren werden daher besonders bevorzugt.

Im Gegensatz dazu enthalten reaktive hitzeaktiviert verklebende Klebemassen reaktive Komponenten. Letztere Bestandteile werden auch als "Reaktivharze" bezeichnet, in denen durch das Erwärmen ein Vernetzungsprozess eingeleitet wird, der nach Beenden der Vernetzungsreaktion eine dauerhafte stabile Verbindung gewährleistet. Bevorzugt enthalten derartige Klebemassen auch elastische Komponenten, zum Beispiel synthetische Nitrilkautschuke oder Stryrolblockcopolymere. Derartige elastische Komponenten verleihen der hitzeaktiviert verklebenden Klebemasse infolge ihrer hohen Fließviskosität eine auch unter Druck besonders hohe Dimensionsstabilität.
Besonders bevorzugt werden als reaktive hitzeaktiviert verklebende Klebemassen diejenigen auf Basis von Styrolblockcopolymeren aufgrund ihres unpolaren Charakters.

Strahlungsaktivierte Klebemassen basieren ebenfalls auf reaktiven Komponenten. Letztere Bestandteile können zum Beispiel Polymere oder Reaktivharze umfassen, in denen durch die Bestrahlung ein Vernetzungsprozess eingeleitet wird, der nach Beenden der Vernetzungsreaktion eine dauerhafte stabile Verbindung gewährleistet. Bevorzugt enthalten derartige Klebemassen auch elastische Komponenten, wie sie oben ausgeführt sind.
Grundsätzlich können auch hier aktivierbare Klebemassen auf Basis von (Meth-)Acrylaten eingesetzt werden; bevorzugt werden aber aktivierbare Klebemassen auf der Basis von Epoxiden, Oxetanen, oder modifizierten Styrolblockcopolymeren, eingesetzt.

Erfindungsgemäß weist die erfindungsgemäße Klebemasse selbst einen Permeatgehalt von weniger als 1000 ppm, bevorzugt von weniger als 500 ppm auf. Die Angabe ppm bezieht sich dabei auf die Relation des enthaltenen Gesamtgewichts an Permeat zum untersuchten Klebemassegewicht, wobei das Permeat Wasser ist. Der Permeatgehalt kann mittels der Gaschromatographie nach VDA 277 bestimmt werden oder im Fall von Wasser nach DIN EN ISO 62 (gravimetrisches Verfahren, Methode 4) oder DIN 53715 (Karl-Fischer-Titration) nach Lagerung des Prüflings über 24 Stunden bei 23°C und 50 % relativer Luftfeuchte. Bei geringen Permeatgehalten der Klebemasse wird die Kapazität der Gettermaterialien nicht so stark durch in der Klebemasse enthaltene Permeate beansprucht, sondern das Klebeband kann seine Funktion als Permeate aus der elektronischen Anordnung selbst bindende oder sogar vor Permeaten aus der Umgebung schützende Abdeckung besser erfüllen.

Zur Herstellung einer gettermaterialhaltigen Klebemasse mit geringem Permeatgehalt wie vorstehend beschrieben ist es vorteilhaft, die Klebemasse vor dem Einbringen des Gettermaterials von einem wesentlichen Anteil des in der Masse selbst enthaltenen Permeats zu befreien. Besonders wichtig ist dies, wenn erfindungsgemäße Klebebänder mit einem geringen Gerttermaterialanteil hergestellt werden. Dies wird besonders vorteilhaft durch ein weiteres Gettermaterial erreicht, welches ebenfalls als Sorbens für das Permeat wirkt, aber während des Herstellungsprozesses des Klebebands wieder aus der Klebemasse entfernt wird.

Beansprucht wird also ein Verfahren zur Herstellung eines wie vorstehend beschriebenen gettermaterialhaltigen Klebebands, bei dem zunächst ein erstes zur Sorption von Wasser befähigtes Gettermaterial zu der Klebemasse zugegeben wird, und dann ein zweites zur Sorption von Wasser befähigtes Gettermaterial zugeben wird, das ausgewählt ist aus Calciumoxid, Calciumsulfat, Calciumchlorid und Zeolithen sowie aus Mischungen von zwei oder mehreren der vorstehenden Substanzen, wobei das erste Gettermaterial vor oder nach der Zugabe des zweiten Gettermaterials durch Filtern, Absetzen und Abdekantieren, Fällen, Zentrifugieren oder chemische Umsetzung aus der in fluidem Zustand vorliegenden Masse entfernt wird, und sodann ein Klebeband ausgeformt wird.

Im Unterschied zum Entfernen von Permeat aus den einzelnen Rohstoffen einer Klebemasse bietet das erfindungsgemäße Verfahren den Vorteil, dass Permeat gleichzeitig aus im Wesentlichen allen Bestandteilen einer Klebemasseformulierung entfernt wird und somit der Aufwand geringer ist. Weiterhin wird auch solches Permeat erfasst, welches über Herstell- und/oder Transportvorrichtungen in die Klebemasse eingebracht wird.

Das erfindungsgemäße Verfahren soll nicht ausschließen, dass weitere Komponenten der Klebemasse nach Zugabe oder Entfernung des ersten Gettermaterials bzw. nach Zugabe des zweiten Gettermaterials in die Klebemasseformulierung zugegeben werden. Diese können auch separat von Permeat befreit werden.

Dieses Verfahren wird in einem fluiden Zustand der Klebemasse durchgeführt. Bevorzugt ist eine Schmelze, eine Lösung oder eine Dispersion. In diesem Zustand können die Gettermaterialien leicht verteilt werden und auch die Abtrennung des ersten Gettermaterials ist einfach mit dem Fachmann bekannten Trennverfahren durchzuführen, das heißt Filtern, Absetzen und Abdekantieren, Fällen oder Zentrifugieren, wobei eine chemische Umsetzung des Gettermaterials - unabhängig von einer ggf. auftretenden chemischen Umsetzung durch das Permeat - vor dem Abtrennen nicht ausgeschlossen werden soll..

Das erste und das zweite Gettermaterial können dabei (chemisch) gleich oder verschieden sein. Sind sie gleich, ist es bevorzugt, dass sie zumindest ein Merkmal aufweisen, anhand dessen sie sich trennen lassen, z.B verschiedene Partikelgröße oder Dichte. Dies ist aber nicht zwingend notwendig, da das erste Gettermaterial erfindungsgemäß auch bereits vor der Zugabe des zweiten Gettermaterials wieder aus der Klebemasse entfernt werden kann.

Generell bevorzugt wird, dass das erste Gettermaterial eine größere Partikelgröße aufweist als das zweite Gettermaterial. Dann lässt sich das erste Gettermaterial leicht herausfiltern. So können z.B. Zeolithkugeln mit einen Durchmesser von mehr als 100 µm, bevorzugt mehr als 500 µm, zum Binden von Wasser eingesetzt werden, wie dies in den Beispielen erläutert ist.

Als Gettermaterialien können grundsätzlich alle bereits zuvor genannten Gettermaterialien eingesetzt werden. Bevorzugt liegt das erste Gettermaterial als disperse Phase vor, besonders bevorzugt als partikulär dispergierte Phase und nicht als molar dispergierte Phase.

Erfindungsgemäß hat die Klebemasse eine geringe Permeationsrate für das zu immobilisierende Permeat Wasserdampf. Die Wasserdampfpermeationsrate (WVTR) beträgt weniger als 50 g/(m² d), bevorzugt weniger als 20 g/(m² d) bezogen auf eine Klebemassedicke von 50 µm. Die WVTR wird dabei bei 38 °C und 90 % relativer Luftfeuchtigkeit nach ASTM F-1249, die Sauerstoffpermeationsrate (OTR) bei 23 °C und 50 % relativer Luftfeuchtigkeit nach DIN 53380-Teil 3 gemessen.

Durch die geringe Permeationsrate der Klebemasse diffundiert weniger Permeat aus der Umgebung durch die Klebemasse hindurch in die gettermaterialhaltige Klebemasse, die somit seine Funktion trotz geringem Gettergehalt länger erfüllen oder mit einer noch geringeren Menge an Gettermaterial ausgerüstet werden kann, was Kosten spart.

Als (Haft-)Klebemassen mit inhärenter Barrierewirkung, die bei einer Dicke von 50 µm eine Wasserdampfpermeationsrate von weniger als 50 g/(m²·d) und gegebenenfalls eine Sauerstoffdurchtrittsrate von weniger als 5000 g/(m²·d·bar) aufweisen, lassen sich beispielweise - ohne die Absicht einer Einschränkung auf die genannten Beispiel - einsetzen:
- Klebemassen auf Basis von Vinylaromatenblockcopolymeren,
   - insbesondere wie sie beispielsweise in der DE 10 2008 047 964 A dargestellt sind. Dies sind insbesondere Haftklebmassen. In einer vorteilhaften Ausgestaltung enthalten solche Haftklebemasse Polymerblöcke die aus Vinylaromaten gebildet sind, insbesondere aus Styrol; weiterhin enthalten sie vorteilhaft Polymerblöcke, die durch Polymerisation von 1,3-Dienen, insbesondere Butadien und/oder Isopren, gebildet sind, und/oder spezifisch oder vollständig hydrierte Polymerblöcke Der Polyvinylaromatenanteil der Blockcopolymere beträgt vorteilhaft 10 Gew.-% bis 35 Gew.-%. In bevorzugter Weise weist die Haftklebemasse einen Anteil der Vinylaromatenblockcopolymere von mindestens 20 Gew.-%, vorzugsweise von mindestens 30 Gew.-%, weiter bevorzugt von mindestens 35 Gew.-%, auf; und/oder sie weist einen Anteil der Vinylaromatenblockcopolymere von maximal 80 Gew.-%, vorzugsweise von maximal 65 Gew.-%, weiter bevorzugt von maximal 60 Gew.-%, auf. Die Haftklebemasse kann ein oder mehrere Harze oder ein oder mehrere Harzgemische enthalten, vorzugsweise hydrierte Harze mit einem Hydrierungsgrad von mindestens 90%, weiter bevorzugt von mindestens 95%. In einer bevorzugten variante enthält sie zumindest ein Harz, das einen DACP-Wert von mehr als 30 °C und einen MMAP-Wert von mehr als 50 °C aufweist, vorzugsweise einen DACP-Wert von mehr als 37 °C und einen MMAP-Wert von mehr als 60 °C, und/oder die Haftklebemasse enthält zumindest ein Harz, das eine Erweichungstemperatur von mehr als 95 °C, insbesondere von mehr als 100 °C aufweist. Es können ein oder mehrere Addtive enthalten sein, vorzugsweise ausgewählt aus der Gruppe bestehend aus: Plastifizierungsmitteln, primären Antioxidanzien, sekundären Antioxidanzien, Prozessstabilisatoren, Lichtschutzmitteln, Verarbeitungshilfsmittel, Endblockverstärkerharzen, Polymeren, insbesondere elastomerer Natur. Vorteilhaft ist es, wenn die Haftklebemasse, insbesondere nach einer Vernetzung, eine Reißdehnung von mindestens 20 % aufweist,
   - insbesondere wie sie beispielweise in der DE 10 2009 036 970 A beschrieben sind. Genannt seien insbesondere teilweise vernetzte Haftklebmasse auf Basis von säureoder säureanhydridmodifizierten Vinylaromatenblockcopolymeren. Sehr vorteilhaft enthält die Haftklebemasse Polymerblöcke gebildet aus Vinylaromaten, insbesondere Styrol. Weiter vorteilhaft sind solche Haftklebemassen auf Basis von säure- oder säureanhydridmodifizierten Vinylaromatenblockcopolymeren, die Polymerblöcke gebildet durch Polymerisation von 1,3-Dienen, insbesondere Butadien und/oder Isopren, und/oder spezifisch oder vollständig hydrierte Polymerblöcke enthält.

   Diese Haftklebemassen können vorteilhaft mit Aminen und/oder Epoxidharzen und/oder Metallchelaten vernetzt sein. Als Metallchelate können bevorzugt solche verwendet werden, die durch die Formel (R₁O)ₙ M (XR₂Y)ₘ wiedergegeben werden können, wobei M ein Metall der 2. 3. 4. und 5. Hauptgruppe oder ein Übergangsmetall ist; R₁ eine Alkyloder Arylgruppe wie Methyl, Ethyl, Butyl, Isopropyl oder Benzyl ist; n null oder eine größere ganze Zahl ist, X und Y Sauerstoff oder Stickstoff sind, die jeweils auch durch eine Doppelbindung an R2 gebunden sein können; R₂ eine X und Y verbindende Alkylengruppe ist, die verzweigt sein kann, oder auch Sauerstoff oder weitere Heteroatome in der Kette enthalten kann; m eine ganze Zahl, mindestens jedoch 1 ist. Vorteilhaft kann es sich bei dem Chelat um ein Acetylacetonat handelt, insbesondere um Aluminiumacetylacetonat.
   In einer vorteilhaften Ausführung weisen die Blockcopolymere einen Polyvinylaromatenanteil von 10 Gew.-% bis 35 Gew.-% aufweisen. Der Anteil der Vinylaromatenblockcopolymere in der Haftklebemasse beträgt bevorzugt mindestens 30 Gew.-%, vorzugsweise mindestens 40 Gew.-%, weiter bevorzugt mindestens 45 Gew.-%. Vorteilhaft sollte der Anteil der Vinylaromatenblockcopolymere in der Haftklebemassen 80 Gew.-%, vorzugsweise 70 Gew.-%, nicht übersteigen.
   Die Haftklebemasse kann ein Harz oder ein Harzgemisch enthalten, vorzugsweise hydrierte Harze mit einem Hydrierungsgrad von mindestens 90%, weiter bevorzugt von mindestens 95%. Die Haftklebemasse kann ein oder mehrere Additive enthalten, vorzugsweise ausgewählt aus der Gruppe umfassend Plastifizierungsmitteln, primären Antioxidanzien, sekundären Antioxidanzien, Prozessstabilisatoren, Lichtschutzmitteln, Verarbeitungshilfsmittel, Endblockverstärkerharzen, Polymeren, insbesondere elastomerer Natur. Die Haftklebemasse kann einen oder mehrere Füllstoffe enthalten, wie nanoskalige Füllstoffe, transparente Füllstoffe. Vorteilhaft sind die Füllstoffe in mindestens einer Dimension nanoskalig ausgebildet.
- Klebemassen auf Polyolefinbasis, insbesondere wie sie beispielsweise in der DE 10 2008 062 130 A beschrieben sind. Haftklebemassen auf Basis eines teilkristallinen Polyolefins sind besonders bevorzugt, wobei das Polyolefin eine Dichte zwischen 0,86 und 0,89 g/cm, bevorzugt zwischen 0,86 und 0,88 g/cm³, sehr bevorzugt zwischen 0,86 und 0,87 g/cm³, und einen Kristallitschmelzpunkt von mindestens 90°C, bevorzugt von mindestens 115°C, sehr bevorzugt von mindestens 135°C aufweist. Vorteilhaft ist das Polyolefin mit mindestens einem Klebharz kombiniert, wobei vorzugsweise die Menge an Klebharz 130 bis 350 phr, besonders bevorzugt 200 bis 240 phr beträgt. Weiter vorteilhaft enthält die Haftklebemasse ein hydriertes Harz, vorzugsweise mit einem Hydrierungsgrad von mindestens 90%, besonders bevorzugt von mindestens 95%. Es können ein oder mehrere Additive enthalten sein, vorzugsweise ausgewählt aus der Gruppe bestehend aus: Weichmacher, primären Antioxidanzien, sekundären Antioxidanzien, Prozessstabilisatoren, Lichtschutzmitteln, Verarbeitungshilfsmittel, UV-Blocker.
- Klebemassen auf Isobutylenbasis und/oder auf Butylenblockcopolymerbasis, insbesondere solche beispielsweise gemäß der DE 10 2008 060 113 A. Besonders bevorzugt sind Haftklebmassen auf Basis von Isobutylenblockcopolymeren. Bevorzugt enthält die Haftklebemasse Polymerblöcke gebildet aus Vinylaromaten, insbesondere Styrol, enthält, und Polymerblöcke, die durch Polymerisation von Isobutylen oder von Isobutylen in Kombination mit n-Buten und/oder 1,3-Dienen, insbesondere Butadien und/oder Isopren, gebildet werden. Die Blockcopolymere weisen bevorzugt einen Polyvinylaromatenanteil von 10 Gew.-% bis 35 Gew.-%. Bevorzugt beträgt der Anteil der Blockcopolymere an der Haftklebemasse mindestens 20 Gew.-%, vorzugsweise mindestens 30 Gew.-%, weiter bevorzugt mindestens 35 Gew.-%, und/oder maximal 90 Gew.-%, vorzugsweise maximal 75 Gew.-%, weiter bevorzugt maximal 70 Gew.-%. Es ist von Vorteil, wenn der Anteil der Isobutylenblockcopolymere am Gesamtanteil der Blockcopolymere mindestens 40 Gew.%, vorzugsweise mindestens 55 Gew.-% beträgt. Die Haftklebemasse kann ein Harz oder ein Harzgemisch enthalten; vorzugsweise enthält sie hydrierte Harze mit einem Hydrierungsgrad von mindestens 90%, weiter bevorzugt von mindestens 95%. Das in der Haftklebemasse enthaltenen Harz weist bevorzugt einen DACP-Wert von mehr als 30 °C und einen MMAP-Wert von mehr als 50 °C, vorzugsweise einen DACP-Wert von mehr als 37 °C und einen MMAP-Wert von mehr als 60 °C, und/oder eine Erweichungstemperatur von mehr als 95 °C, insbesondere von mehr als 100 °C auf. Es können ein oder mehrere Additive enthalten sein, vorzugsweise ausgewählt aus der Gruppe bestehend aus: Plastifizierungsmitteln, primären Antioxidanzien, sekundären Antioxidanzien, Prozessstabilisatoren, Lichtschutzmitteln, Verarbeitungshilfsmittel, Endblockverstärkerharzen, Polymeren, insbesondere elastomerer Natur.
- aktivierbare Klebemassen, insbesondere wie sie in der DE 10 2009 036 986 A dargestellt werden. Bevorzugt sind dies thermisch aktivierbare Haft- oder Heißschmelzklebemassen, die vorteilhaft durch Ultraschall oder magnetische Induktion erzeugte Wärme aktiviert werden können, insbesondere wird die Wärme durch geeignete aktivierbare Zusätze im Innern der Klebemasse erzeugt. Hierzu können in der Klebemasse beispielweise Eisenoxid-Teilchen, die von Siliziumdioxid umhüllt sind, vorgesehen sein.
- Klebemassen auf Basis von Epoxiden, wie beispielweise Epoxidharzen, insbesondere wie sie beispielsweise in der US 2010/0137530 A beschrieben sind. Diese Schrift zeigt insbesondere photohärtbare Zusammensetzungen umfassend (A) ein Epoxidharz mit mindestens zwei Glycidylgruppen in jedem Molekül und mit einem zahlenmittleren Molekulargewicht Mn von 200 bis 7000, (B) ein Epoxidharz mit mindestens einer Glycidylgruppe in jedem Molekül und mit einem zahlenmittleren Molekulargewicht von 20000 bis 100000, (C) einen latent sauren Photokatalysator, der durch Bestrahlung die Säurefunktionalität aktivieren kann, sowie (D) einem Silan-Haftvermittler mit mindestens einer Glycidylgruppe in jedem Molekül, worin die Menge der Komponente (B) 30 bis 150 Gew.-Teile, bezogen auf 100 Gew.-Teile der Komponente (A), ausmacht, und worin die Mengen der Komponenten (C) und (D) jeweils 0,1 bis 10 Gew-Teile, bezogen auf 100 Gew.-Teile der Komponenten (A) und (B) gemeinsam,, ausmachen, und wobei die Zusammensetzung bei 25 °C nicht fließfähig, in einem Bereich von 50 °C bis 100 °C aber fließfähig ist.
- Klebemassen auf Polyamidbasis, insbesondere wie beispielweise in der DE 10 2006 047 739 A vorgestellt. Diese Schrift zeigt hitzeaktivierbare Klebemassen, die zumindest aus a) einem Polyamid mit Amino- und/oder Säureendgruppen, b) einem Epoxidharz, und c) gegebenenfalls einem Weichmacher bestehen, wobei das Polyamid bei Temperaturen von mindestens 150 °C mit dem Epoxidharz reagiert und das Verhältnis in Gewichtsanteilen von a) und b) zwischen 50:50 bis 99:1 liegt. Vorteilhaft handelt sich bei dem Polyamid um ein nicht kristallines Copolyamid wie PA 6,6/6,12 oder PA 6,6/6,11. Die Viskositätszahl des Polyamids in 96 %iger Schwefelsäure nach ISO 307 gemessen beträgt bevorzugt 100 bis 130 ml/g. Als Weichmacher können beispielweise Phthalate, Trimellitate, Phosphorsäureester, natürliche Öle, Polyalkylenoxide, Kolophoniumharze und/oder Polyethylenglycol gewählt werden. Der Anteil des Weichmachers beträgt bevorzugt zwischen 5 Gew.-% und 45 Gew.-% an der Gesamtmasse der Klebemasse. Der Klebemasse können vorteilhaft Additive zugemischt sein, wie Beschleuniger, Farbstoffe, Ruß und/oder Metallpulver.
- Klebemassen umfassend (a) zumindest ein Copolymer enthaltend zumindest Isobutylen oder Butylen als Comonomersorte und zumindest eine Comonomersorte, die - als hypothetisches Homopolymer betrachtet - eine Erweichungstemperatur von größer 40 °C aufweist, (b) zumindest eine Sorte eines zumindest teilhydrierten Klebharzes, (c) zumindest eine Sorte eines Reaktivharzes basierend auf cyclischen Ethern mit einer Erweichungstemperatur von kleiner 40 °C, bevorzugt kleiner 20 °C, (d) zumindest eine Sorte eines Photoinitiators für die Initiierung einer kationischen Härtung; und Klebemassen umfassend (a) zumindest ein Copolymer enthaltend zumindest Isobutylen oder Butylen als Comonomersorte und zumindest eine Comonomersorte, die - als hypothetisches Homopolymer betrachtet - eine Erweichungstemperatur von größer 40 °C aufweist, (b) zumindest eine Sorte eines zumindest teilhydrierten Klebharzes, (e) zumindest eine Sorte eines Reaktivharzes basierend auf Acrylaten oder Methacrylaten mit einer Erweichungstemperatur von kleiner 40 °C, bevorzugt kleiner 20 °C, (d) zumindest eine Sorte eines Photoinitiators für die Initiierung einer kationischen Härtung.
   Das oder die Copolymere können beispielweise statistische, alternierende, Block-, Stern- und/oder Pfropfcopolymere mit einer Molmasse M_{w} von 300.000 g/mol oder kleiner, bevorzugt 200.000 g/mol oder kleiner sind. Das oder die Copolymere Block-, Stern- und/oder Pfropfcopolymere weisen in einer bevorzugten Ausführungsform zumindest eine Sorte eines ersten Polymerblocks ("Weichblock") mit einer Erweichungstemperaturvon kleiner -20 °C und zumindest eine Sorte eines zweiten Polymerblocks ("Hartblock") mit einer Erweichungstemperatur von größer +40 °C auf. Dabei kann der Weichblock unpolar aufgebaut sein und Butylen oder Isobutylen als Homopolymerblock oder Copolymerblock enthalten, letztere vorzugsweise mit sich selbst oder miteinander oder mit weiteren besonders bevorzugt unpolaren Comonomeren copolymerisiert. Vorteilhaft ist es, wenn der Hartblock aus Styrol, Styrol-Derivaten und/oder aus anderen aromatischen oder (cyclo-)aliphatischen Kohlenwasserstoffmonomeren oder aus Methacrylaten oder aus Acrylaten aufgebaut ist. Weiter vorteilhaft ist es, wenn es sich bei dem zumindest einen Blockcopolymer um ein Triblockcopolymer handelt, das aus zwei endständigen Hartblöcken und einem mittelständigen Weichblock aufgebaut ist. Das oder die Klebharze weisen bevorzugt einen Hydrierungsgrad von mindestens 70 %, weiter bevorzugt von mindestens 95 % auf. Vorteilhaft kann die Klebemasse ein oder mehrere Additive, unabhängig voneinander gewählt aus der folgenden Gruppe, enthalten: • Harze, die einen DACP-Wert von mehr als 30 °C und einen MMAP-Wert von mehr als 50 °C aufweisen, vorzugsweise einen DACP-Wert von mehr als 37 °C und einen MMAP-Wert von mehr als 60 °C; • Reaktivharze, die zumindest eine Epoxid- oder zumindest eine Oxetan-Gruppe tragen; • Reaktivharze aliphatischer oder cycloaliphatischer Natur, • Photoinitiatoren, die unterhalb 350 nm UV-Licht absorbieren und die eine kationische Härtung erlauben, insbesondere Sulfonium-, lodonium- und Metallocen-basierende Systeme; • Photoinitiatorent, die oberhalb 250 nm und unterhalb 350 nm UV-Licht absorbieren; • Plastifizierungsmitteln, • primäre Antioxidantien, • sekundären Antioxidantie, • Prozessstabilisatoren, • Lichtschutzmitteln, • Verarbeitungshilfsmittel, • Endblockverstärkerharzen, • Polymere, insbesondere elastomerer Natur; • Füllstoffe, vorzugsweise nanoskalige Füllstoffe, transparente Füllstoffe und/oder Getter-und/oder Scavenger-Füllstoffe. In einer bevorzugten Ausführungsform ist die Klebemasse im sichtbaren Licht des Spektrums (Wellenlängenbereich von etwa 400 nm bis 800 nm) transparent und/oder zeigt einen Haze kleiner 5,0 %, bevorzugt kleiner 2,5 %.

Auf die in den jeweils genannten Schriften offenbarten Sachverhalte wird explizit Bezug genommen. Die Nennung der vorgenannten Beispiele soll die Wahl der erfindungsgemäß geeigneten Klebemassen nicht unnötig beschränken.

Ein weiterer Gegenstand der Erfindung ist ein Klebeband wie vorstehend beschrieben, in Form eines Transferklebeband umfassend zumindest eine wie vorstehend beschriebene Schicht einer gettermaterialhaltigen Haftklebemasse oder einer aktivierbaren Klebemasse und insbesondere einer aktivierbaren Haftklebemasse, wobei die Klebemasse ein Gettermaterial zu einem Anteil von weniger als 2 Gew.-% enthält. Das Klebeband kann auch weitere Schichten enthalten, zum Beispiel eine oder mehrere weitere Klebemasseschichten oder ein Trägermaterial.

Weitere Einzelheiten, Merkmale und Vorteile der vorliegenden Erfindung werden nachfolgend anhand bevorzugter Ausführungsbeispiele näher erläutert. In der Zeichnung zeigt
Fig. 1 eine (opto-)elektronische Anordnung nach dem Stand der Technik in schematischer Darstellung,
Fig. 2 eine erste erfindungsgemäße (opto-)elektronische Anordnung in schematischer Darstellung,
Fig. 3 eine zweite erfindungsgemäße (opto-)elektronische Anordnung in schematischer Darstellung.

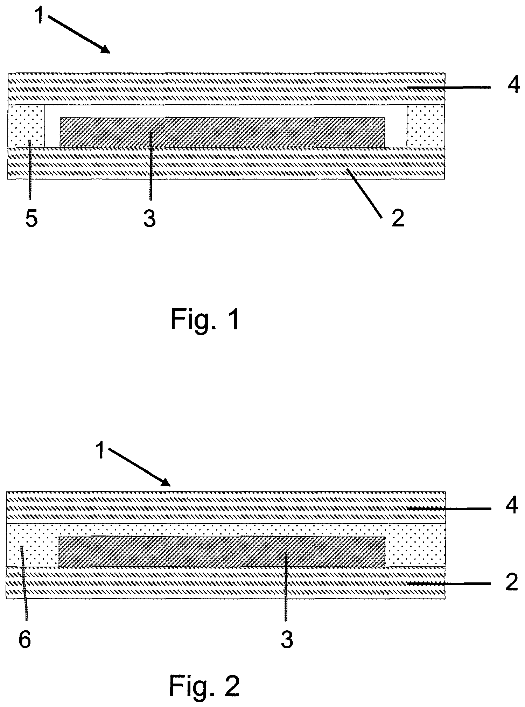

Fig. 1 zeigt eine erste Ausgestaltung einer organischen elektronischen Anordnung 1 nach dem Stand der Technik. Diese Anordnung 1 weist ein Substrat 2 auf, auf dem eine elektronische Struktur 3 angeordnet ist. Das Substrat 2 selbst ist als Barriere für Permeate ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist eine Klebemasse 5 umlaufend neben der elektronischen Struktur 3 auf dem Substrat 2 vorgesehen. Dabei ist es unerheblich, ob die Klebemasse zunächst mit dem Substrat 2 verbunden wurde oder zuerst mit der Abdeckung 4. Die Haftklebemasse 5 verbindet die Abdeckung 4 mit dem Substrat 2. Durch eine entsprechend dicke Ausgestaltung ermöglicht die Haftklebemasse 5 zudem die Beabstandung der Abdeckung 4 von der elektronischen Struktur 3.

Bei der Klebemasse 5 handelt es sich um eine solche nach dem Stand der Technik, also eine Klebemasse mit hoher Permeationsbarriere, die zudem zu einem hohen Anteil mit Gettermaterial gefüllt sein kann. Die Klebemasse 5 übernimmt vorliegend nicht nur die Funktion des Verbindens des Substrats 2 mit der Abdeckung 4 sondern bildet zudem auch eine Barriereschicht für Permeate bereit, um so die elektronische Struktur 2 auch von der Seite gegen Permeate wie Wasserdampf und Sauerstoff zu kapseln. Wird die Klebemasse in Form eines Flüssigklebers aufgebracht, ist ein hoher Anteil an Gettermaterial in der Regel unkritisch, da die fluide Form für ein gutes Auffließen und somit eine gute Abdichtung der Grenzfläche sorgt.

Handelt es sich bei der Klebemasse jedoch um ein Transferklebeband, welches haftklebrig ist oder durch einen Aktivierungsschritt in einen klebrigen Zustand versetzt wird, z.B. durch Erwärmung, ergibt sich bei einem hohen Anteil an Gettermaterial nach der Applikation in der Regel keine vollständige Benetzung der Oberflächen von Substrat und/oder Abdeckung, so dass die Permeationsbarriere an der Grenzfläche gestört ist. Dies macht vielfach trotz des mit Gettermaterial gefüllten Trannsferklebebands das separate Einbringen eines Getterpads in den Gasraum erforderlich.

Ein Transferklebeband würde vorliegend zudem in Form eines Stanzlings bereitgestellt, welcher aufgrund seiner filigranen Geometrie schwieriger handzuhaben ist als ein im Wesentlichen vollflächig appliziertes Transferklebeband.

Fig. 2 zeigt eine erfindungsgemäße Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun das erfindungsgemäße Transferklebeband 6 vollflächig angeordnet. Die elektronische Struktur 3 wird somit von oben vollständig durch das Transferklebeband 6 gekapselt. Auf das Transferklebeband 6 ist sodann eine Abdeckung 4 aufgebracht. Bei dem Transferklebeband 6 handelt es sich um ein solches auf Basis des erfindungsgemäßen Transferklebebands wie es vorstehend in allgemeiner Form beschrieben wurde und nachfolgend in Ausführungsbeispielen näher dargelegt ist. Das Transferklebeband besteht in der dargestellten Ausführung nur aus einer Schicht einer zu einem Anteil von weniger als 2 Gew-% gefüllten Klebemasse.

Die Kombination einer mit Gettermaterial gefüllten Klebemasse mit der vollflächigen Abdeckung zeigt zudem einen weiteren überraschenden synergistischen Effekt: Die elektronische Anordnung degradiert nicht ganzflächig sondern nur langsam zunehmend vom Rand her. Dadurch kann ein großer Teil der Anordnung auch bei erstem Eindringen von Permeaten noch genutzt werden. Durch die dichte Grenzfläche zwischen Transferklebeband und Substrat bzw. Abdeckung sowie auch zur elektronischen Anordnung sind Permeate gezwungen, durch die Klebemasse selbst zu permeieren, in der überraschend die Kombination aus einem geringen Anteil an Gettermaterial mit einer hohen Permeationsbarriere ausreicht, die Lebensdauer in ähnlichem Maße zu verlängern wie ein hoher Gettermaterialanteil.

Dieser Effekt stellte sich überraschend nur ein, wenn die Klebemasse erfindungsgemäß nur zu einem geringen Anteil mit Gettermaterial gefüllt und somit die Grenzfläche zwischen Transferklebeband und Substrat bzw. Abdeckung sowie auch zur elektronischen Anordnung permeationsdicht ist. War die Klebemasse zu einem hohen Anteil mit Gettermaterial gefüllt, konnten Permeate an dieser gestörten Grenzfläche leicht zur elektronischen Anordnung vordringen und diese auch in der Fläche schädigen. Damit war der Schaden schneller offensichtlich. Gleiches war für die nicht vollflächige Anordnung nach Fig. 1 zu beobachten, bei der durchgebrochene Permeate ebenfalls die gesamte Fläche schädigen können.

Die Abdeckung 4 muss im Gegensatz zu der vorherigen Ausgestaltung nicht zwingend die hohen Barriereanforderungen erfüllen, da bei vollflächiger Überdeckung der elektronischen Anordnung durch das Transferklebeband die Barriere bereits durch die Haftklebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

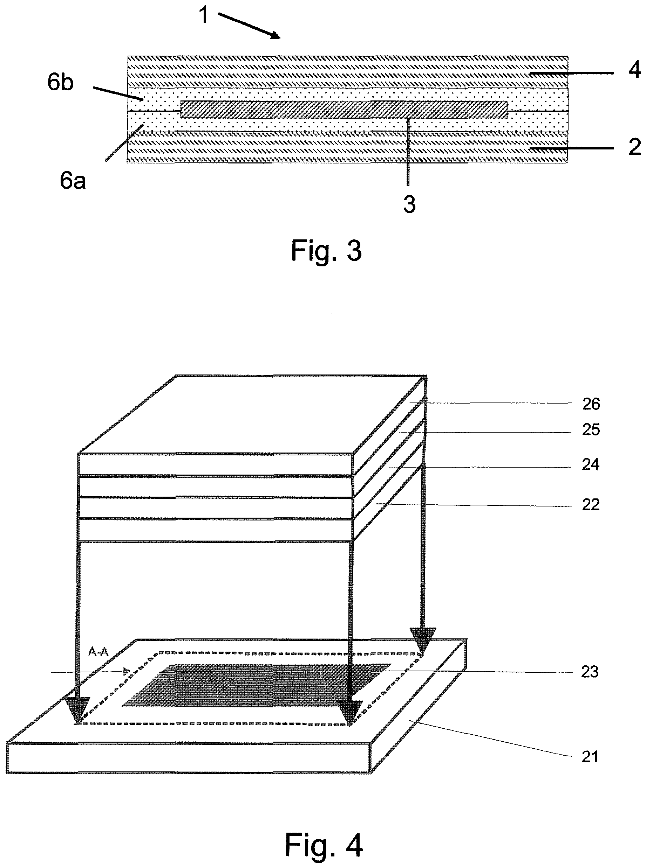

Fig. 3 zeigt eine alternative Ausgestaltung einer (opto-)elektronischen Anordnung 1. Im Gegensatz zu den vorherigen Ausgestaltungen sind nun zwei Transferklebebänder 6a, b vorgesehen, die vorliegend identisch ausgebildet sind, aber auch unterschiedlich sein können. Das erste Transferklebeband 6a ist vollflächig auf dem Substrat 2 angeordnet. Auf dem Transferklebeband 6a ist die elektronische Struktur 3 vorgesehen, die durch das Transferklebeband 6a fixiert wird. Der Verbund aus Transferklebeband 6a und elektronischer Struktur 3 wird dann mit dem weiteren Transferklebeband 6b vollflächig überdeckt, so dass die elektronische Struktur 3 von allen Seiten durch die Transferklebebänder 6a, b gekapselt ist. Oberhalb des Transferklebebands 6b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeaten zur elektronischen Struktur 3 weiter einzuschränken.

Insbesondere im Hinblick auf die Fig. 2 und 3 wird darauf hingewiesen, dass es sich vorliegend um schematische Darstellungen handelt. Aus den Darstellungen ist insbesondere nicht ersichtlich, dass das Transferklebeband hier und vorzugsweise jeweils eine homogene Schichtdicke aufweist. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Ggf. kann jedoch auch eine Anpassung an den Untergrund erfolgen, insbesondere dann, wenn die Applikation unter Vakuum durchgeführt wird. Zudem wird die Klebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Die Dicke des Transferklebebands kann alle üblichen Dicken umfassen, also etwa von 1 µm bis zu 3000 µm. Bevorzugt wird eine Dicke zwischen 25 und 100 µm, da in diesem Bereich Klebkraft und Handlingeigenschaften besonders positiv ausfallen. Ein weiterer bevorzugter Bereich ist eine Dicke von 3 bis 25 µm, da in diesem Bereich die Menge von durch die Klebefuge permeierenden Stoffen allein durch die kleine Querschnittsfläche der Klebefuge in einer Verkapselungsanwendung gering gehalten werden kann.

Zur Herstellung eines erfindungsgemäßen Transferklebebands wird der Träger des Klebebands oder der Liner einseitig mit der gettermaterialhaltigen Klebemasse aus Lösung oder Dispersion oder 100 %ig (zum Beispiel Schmelze) beschichtet oder bedruckt, oder das Klebeband wird durch (Co-)Extrusion hergestellt. Alternativ ist eine Herstellung durch Transfer einer erfindungsgemäßen Klebemasse-Schicht durch Kaschieren auf eine Trägermaterial oder einen Liner möglich. Die Klebemasseschicht kann durch Wärme oder energiereiche Strahlen vernetzt werden.

Bevorzugt findet dieser Herstellprozess in einer Umgebung statt, in der das spezifische Permeat nur in geringer Konzentration oder nahezu gar nicht enthalten ist. Als Beispiel kann eine relative Luftfeuchtigkeit von weniger als 30 %, bevorzugt von weniger als 15 % genannt werden.

Zur Optimierung der Eigenschaften kann die zum Einsatz kommende Klebemasse mit einem oder mehreren Additiven wie Klebrigmachern (Harzen), Weichmachern, Füllstoffen, Pigmenten, UV-Absorbern, Lichtschutzmitteln, Alterungsschutzmitteln, Vernetzungsmitteln, Vernetzungspromotoren oder Elastomeren abgemischt sein.

Die Menge einer Klebstoffschicht beträgt bevorzugt 1 bis 120 g/m², vorzugsweise 10 bis 100 g/m², wobei unter "Menge" die Menge nach einer eventuell durchgeführten Entfernung von Wasser oder Lösungsmittel verstanden wird.

Ein weiterer Gegenstand der vorliegenden Erfindung ist die Verwendung einer Änderung der optischen Eigenschaften des Gettermaterials zur Indikation der Einwandfreiheit des Klebebands. So wird z.B. Calciumoxid mit zunehmender Wasserbindung seine Farbe von weiß zu transparent. So lange also noch Gettermaterial in der optischen Erscheinung des unverbrauchten Zustands erkennbar ist, kann dies als Indiz dafür gelten, dass noch kein oder allenfalls wenig Permeat zur zu schützenden Klebemasse diffundiert ist.

### Beispiele

### Klebemassen:

### K1: Haftklebemasse

| | | |
|---|---|---|
| 100 Teile | Tuftec P 1500 | SBBS mit 30 Gew.-% Blockpolystyrolgehalt der Firma Asahi. Das SBBS enthält ca. 68 Gew.-% Zweiblockgehalt. |
| 100 Teile | Escorez 5600 | Hydriertes KW-Harz mit einem Erweichungspunkt von 100 °C der Firma Exxon |
| 25 Teile | Ondina 917 | Weißöl aus paraffinischen und naphthenischen Anteilen der Firma Shell |

Als Lösungsmittel wurde ein Gemisch aus Toluol und Aceton im Verhältnis 2:1 verwendet.

### K2: Heißschmelzklebemasse

| | | |
|---|---|---|
| 100 Teile | Kraton FG 1924 | Maleinsäureanhydridmodifiziertes SEBS mit 13 Gew.-% Blockpolystyrolgehalt, 36 Gew.-% Zweiblock und 1 Gew.-% Maleinsäure der Firma Kraton |
| 25 Teile | Escorez 5600 | Hydriertes KW-Harz (Kohlenwasserstoffharz) mit einem Erweichungspunkt von 100 °C der Firma Exxon |
| 1 Teil | Aluminiumacetylacetonat | |

Als Lösungsmittel wurde ein Gemisch aus Toluol und Aceton im Verhältnis 2:1 verwendet.

### K3: Strahlenaktivierbare Heißschmelzklebemasse

| | | |
|---|---|---|
| 25 Teile | Epiclon 835 LV | Bisphenol-A und Bisphenol-F basiertes Epoxidharz der Firma DIC, Japan, Molekulargewicht M_{W} ca. 350 g/mol |
| 25 Teile | Epicote 1001 | Bisphenol basiertes Epoxidharz der Firma Mitsubishi Chemical Company, Japan, Molekulargewicht M_{W} ca. 900 g/mol |
| 50 Teile | YP-70 | Bisphenol-A und Bisphenol-F basiertes Phenoxyharz der Fa. Nippon Steel Chemical Group, Japan, Molekulargewicht Mw ca. 55.000 g/mol |
| 1,5 Teile | Irgacure 250 | lodonium-Salz-basierter UV-Photoinitiator der Fa. BASF (Iodonium, (4-methylphenyl) [4-(2-methylpropyl) phenyl]-, hexafluorophosphate(1-)) |

Als Lösemittel wurde Methylethylketon verwendet.

### K4: Hitzeaktivierbare Klebemasse

| | | |
|---|---|---|
| 90 Teile | Ultramid 1C | Copolyamid 6/66/136 der Fa. BASF mit einer Viskositätszahl in 96 %iger Schwefelsäure nach ISO 307 von 122 ml/g |
| 10 Teile | EPR 166 | Bisphenol basiertes Epoxidharz der Firma Bakelite, Epoxidzahl von 184 |
| 20 Teile | PEG 2000 | Polyethylenglycol mit der mittleren Molmasse 2000 |
| 20 Teile | Foralyn 5040 | Klebharz der Firma Eastman |

Die Klebemasse wurde in einem Prozess, wie er in DE102006047739 A1 offengelegt ist, mit Ethanol als Lösemittel hergestellt.

### K5: konventionelle Acrylatklebemasse ohne nennenswerte Permeationsbarriere

Acrylat-Haftklebemasse die als Comonomere 30 Gew.-% Ethylhexylacrylat, 67 Gew.-% Butylacrylat, sowie 3 Gew.-% Acrylsäure enthielt. Zur Herstellung der AcrylatHaftklebemasse wurden die einzelnen Comonomere in dem Fachmann bekannter Weise in einem Gemisch aus Benzin und Aceton polymerisiert.

Von allen Klebemassen wurden die Wasserdampf- (WVTR) und Sauerstoffpermeationsrate (OTR) bestimmt. Dies wurde bei den aktivierbaren Klebemassen im aktivierten, also vernetzten, Zustand durchgeführt.

Die WVTR wurde dabei bei 38°C und 90% relativer Luftfeuchtigkeit nach ASTM F-1249, die OTR bei 23°C und 50% relativer Luftfeuchtigkeit nach DIN 53380-Teil 3 gemessen.

Folgende Permeationsraten wurden ermittelt (normiert auf eine Dicke von 50 µm):

| Klebemasse | WVTR [g/m² d] | OTR [cm³/m² d bar] |
|---|---|---|
| K1 | 37 | 12500 |
| K2 | 22 | 5000 |
| K3 | 32 | 400 |
| K4 | 220 | 120 |
| K5 (Vergleichsbeispiel) | 620 | 25000 |

Alle Klebemasselösungen wurden mittels Zugabe von Zeolith (Molecular Sieves 4 Ä des Lieferanten Sigma-Aldrich) getrocknet, bevor das Gettermaterial zugegeben wurde.

### Verwendete Gettermaterialien:

| Bezeichnung | Beschreibung | Handelsname | Lieferant |
|---|---|---|---|
| G1 | Calciumoxid | Calcium oxide nanopowder | Sigma-Aldrich |
| G2 | Calciumsulfat | CA-5^{™} Calcium Sulfate Filler | United States Gypsum Company |
| G3 | Calciumchlorid | CA-CL-02-NP (Nanoparticles) | American Elements |
| G4 | Silica | Aerosil 380 | Evonik Degussa |
| G5 | Zeolith 3A | Purmol 3 STH | Zeochem |

### Herstellung von Transferklebebändern:

Die Herstellung der Klebebänder erfolgte in einer Glovebox unter Stickstoffatmosphäre bei 23°C und 1 ppm Wassergehalt.

Zur Herstellung von Transferklebebändern wurden die verschiedenen Klebemassen aus einer Lösung auf einen konventionellen permeationsdichten Liner des Typs ALU I 38 UV1 der Firma Mondi, enthaltend einen Träger aus Aluminiumfolie, mittels eines Laborstreichgeräts aufgebracht und getrocknet. Die Klebemassenschichtdicke nach dem Trocknen betrug jeweils 25 µm. Die Trocknung erfolgte jeweils bei 120 °C über 30 min in einem Trockenofen. Unmittelbar nach der Trocknung wurden die Klebemasseschichten auch auf der offenen Seite mit dem o.g. Liner eingedeckt. Die beispielhaft hergestellten erfindungsgemäßen Transferklebebänder bestanden also jeweils nur aus einer Schicht einer Klebemasse.

Als Vergleichsbeispiele wurden Transferklebebänder mit höheren als den erfindungsgemäßen Gettergehalten hergestellt.

Die gettergefüllten Transferklebebänder wurden unmittelbar nach der Herstellung in vakuumierte Beutel aus einem permeationsdichten Folienlaminat (Polyesterfolie-Aluminiumfolie-Siegelkleberfilm) eingeschweißt, in der Glovebox unter Stickstoffatmosphäre gelagert und erst unmittelbar vor der Verwendung entnommen.

### Folgende Transferklebebänder wurden hergestellt:

| **Beispiel** | **Klebemasse** | **Gettermaterial** | **Anteil [Gew.-**%] |
|---|---|---|---|
| 1 | K1 | G1 | 0,2 |
| 2 | K1 | G1 | 1 |
| 3 | K1 | G1 | 2 |
| 4 | K2 | G5 | 1 |
| 5 | K3 | G1 | 1 |
| 6 | K3 | G2 | 0,2 |
| 7 | K3 | G2 | 1 |
| 8 | K3 | G2 | 2 |
| 9* | K4 | G4 | 0,2 |
| 10* | K4 | G4 | 1 |
| 11* | K4 | G4 | 2 |
| Vergleichsbeispiele | | | |
| V1 | K1 | G1 | 5 |
| V2 | K1 | G1 | 20 |
| V3 | K2 | G5 | 5 |
| V4 | K2 | G5 | 20 |
| V5 | K3 | G1 | 20 |
| V6 | K3 | G2 | 5 |
| V7 | K3 | G2 | 20 |
| V8 | K4 | G4 | 5 |
| V9 | K4 | G4 | 20 |
| V10 | K5 | G1 | 1 |
| V11 | K5 | G1 | 5 |
| V12 | K5 | G1 | 20 |

| | | | |
|---|---|---|---|
| *nicht erfindungsgemäß | | | |

Von den Beispielen 1-4 sowie den Vergleichsbeispielen V1 - V4 sowie V10 - V12 wurden die Klebkräfte auf Stahl analog ISO 29862 (Methode 3) bei 23 °C und 50 % relativer Luftfeuchte mit einer Abzugsgeschwindigkeit von 300 mm/min und einem Abzugswinkel von 180° bestimmt. Als Verstärkungsfolie wurde eine geätzte PET-Folie mit einer Dicke von 50 µm verwendet, wie sie von der Fa. Coveme (Italien) erhältlich ist.

Die Verklebung des Messtreifens wurde dabei mittels eines Laborlaminators bei einer Temperatur von 60 °C vorgenommen. Nur die Klebemasse K2 wurde bei einer Temperatur von 120 °C verklebt. Die Klebebänder wurden 14 Tage nach der Applikation abgezogen.

Die Beispiele zeigen jeweils, dass die Klebkraft bei den Klebemassen mit einem Gettermaterialgehalt im erfindungsgemäßen Bereich bis zu einem nach dem Stand der Technik geringen Gettergehalt im Bereich von 5 Gew.-% kaum abnimmt. Entsprechend erwartet der Fachmann hier auch keine wesentliche Abnahme der Permeationsbarriere. Dies wird aber durch die Lebensdauertests überraschend widerlegt.

### Lebensdauertest:

Als ein Maß für die Bestimmung der Lebensdauer eines elektronischen Aufbaus wurde ein Calciumtest herangezogen. Dieser ist in der Figur 4 gezeigt. Dazu wird im Vakuum eine 20 × 20 mm² große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (26 × 26 mm²) mit der zu testenden Klebemasse 22 sowie einer Dünnglasscheibe 24 (35 µm, Firma Schott) als Trägermaterial verwendet. Zur Stabilisierung war die Dünnglasscheibe mit einer 100 µm dicken PET-Folie 26 mittels eines 50 µm dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 3 mm (A-A) abdeckt. Aufgrund des undurchlässigen Glasträgers 24 wird nur die Permeation durch den Haftkleber oder entlang der Grenzflächen ermittelt.

Die Applikation erfolgte mittels eines Rollenlaminators bei spezifischen Temperaturen für jede Klebemasse. Bei Klebemasse 3 erfolgte nachfolgend eine Bestrahlung mit UV-Licht mittels eines Quecksilberdampf-Mitteldruckstrahlers mit einer UV-C-Dosis von ca. 200 mJ/cm² (ermittelt mit dem Gerät UV-Power Puck der Fa. EIT (USA) im Wellenlängenbereich von 250 - 260 nm). Bei Klebemasse 4 erfolgte ein Heißpressschritt bei einer Temperatur von 160 °C und einem Druck von etwa 1 MPa:

| **Klebemasse** | **Laminiertemperatur** |
|---|---|
| K1 | 60 °C |
| K2 | 120°C |
| K3 | 100 °C |
| K4 | 140°C |

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet. Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 60 °C und 90 % relative Luftfeuchte gewählt. Die Muster wurden mit einer Schichtdicke der Haftklebemasse von 25 µm vollflächig und blasenfrei verklebt. Der Messwert (in h) ergab sich als Mittelwert aus drei Einzelmessungen.

Folgende Tabelle fasst die Ergebnisse der Klebkraftbestimmungen und des Lebensdauertests zusammen:

| **Beispiel** | **Klebkraft auf Stahl [N/cm]** | **Lebensdauer [h]** |
|---|---|---|
| 1 | 7,3 | 239 |
| 2 | 7,4 | 388 |
| 3 | 7,0 | 591 |
| 4 | 5,3 | 572 |
| 5 | | 915 |
| 6 | | 305 |
| 7 | | 562 |
| 8 | | 763 |
| 9* | | 78 |
| 10* | | 93 |
| 11* | | 125 |
| Vergleichsbeispiele | | |
| V1 | 6,8 | 684 |
| V2 | 5,4 | 64 |
| V3 | 5,0 | 610 |
| V4 | 3,4 | 46 |
| V5 | | 290 |
| V6 | | 726 |
| V7 | | 23 |
| V8 | | 119 |
| V9 | | 27 |
| V10 | 5,3 | 19 |
| V11 | 5,0 | 24 |
| V12 | 3,1 | 41 |

| | | |
|---|---|---|
| *nicht erfindungsgemäß | | |

Überraschend zeigen beim Lebensdauertest erfindungsgemäße Transferklebebänder eine Lebensdauer in einer ähnlichen Größenordnung wie Klebebänder nach dem Stand der Technik (vergleiche Beispiele 1-3 mit V1-V2, 4 vs. V3-V4). Für einige Beispiele erreichen erfindungsgemäße Klebebänder sogar höhere Lebensdauern als Klebebänder, die nach dem Stand der Technik bereits als nur zu einem geringen Anteil mit Gettermaterial gefüllt gelten (vergleiche Beispiele 5 vs. V5, 6-8 vs. V6-V7).

Die Vergleichsbeispiele V10-V12 zeigen auf, dass der synergistische Effekt nicht bei Klebemassen auftritt, die bereits eine hohe Permeationsrate von Permeaten aufweisen, die im Lebensdauertest zu einem Abbau des Calciums führen. In Relation zu den Beispielen tritt der Effekt nur bei der Verwendung von Klebemassen auf, die bereits eine hohe Permeationsbarriere darstellen, welche bei einer Dicke von 50 µm eine Wasserdampfpermeationsrate von weniger als 50 g/m²d und gegebenenfalls eine Sauerstoffpermeationsrate von weniger als 5000 g/m²d bar aufweisen.

## Patentansprüche

1. Verfahren zum Schutz einer auf einem Substrat angeordneten elektronischen Anordnung umfassend organische Bestandteile,
wobei eine Abdeckung derart auf die elektronische Anordnung aufgebracht wird, dass die elektronische Anordnung zumindest teilweise durch die Abdeckung überdeckt wird,
wobei die Abdeckung zumindest teilflächig auf dem Substrat und/oder auf der elektronischen Anordnung verklebt wird, wobei die Verklebung mittels zumindest einer Schicht einer Klebemasse in einem Klebeband bewirkt wird,
**dadurch gekennzeichnet, dass**
eine Klebemasse eingesetzt wird, die, ausgeformt zur Schicht mit einer Dicke von 50 µm, eine Wasserdampfpermetationsrate von weniger als 50 g/m²d aufweist, wie bei 38 °C und 90 % relativer Luftfeuchtigkeit nach ASTM F-1249 gemessen,
die Klebemasse einen Permeatgehalt von weniger als 1000 ppm wie nach DIN 53715 nach Lagerung über 24 Stunden bei 23 °C und 50 % relativer Luftfeuchte bestimmt enthält, bezogen auf die Relation des enthaltenen Gesamtgewichts an Permeat zum Klebemassengewicht, wobei das Permeat Wasser ist, und
die Klebemasse ein zur Sorption von Wasser befähigtes Gettermaterial umfasst, wobei das Gettermaterial ausgewählt ist aus Calciumoxid, Calciumsulfat, Calciumchlorid und Zeolithen sowie aus Mischungen von zwei oder mehreren der vorstehenden Substanzen, und wobei das Gettermaterial zu einem Anteil von nicht mehr als 2 Gew.-% und mindestens 0,5 Gew.-%, jeweils bezogen auf die Klebemasse mit dem Gettermaterial, in der Klebemasse vorliegt.

2. Verfahren nach Anspruch 1, **dadurch gekennzeichnet, dass**
das Klebeband ein einschichtiges Klebeband aus der Klebemassenschicht ist.

3. Verfahren nach einem der vorhergehenden Ansprüche, **dadurch gekennzeichnet, dass**
der Anteil des Gettermaterials in der Klebemasse nicht mehr als 1 Gew.-% beträgt.

4. Verfahren nach einem der vorangehenden Ansprüche, **dadurch gekennzeichnet, dass**
das Gettermaterial nanoskalig vorliegt,
insbesondere derart, dass die Ausdehnung in mindestens einer Dimension nicht mehr als 500 nm, bevorzugt nicht mehr als 200 nm, sehr bevorzugt nicht mehr als 100 nm beträgt.

5. Verfahren nach einem der vorangehenden Ansprüche, **dadurch gekennzeichnet, dass**
die Klebemasse eine Sauerstoffpermeationsrate von weniger als 5000 g/m²d bar, wie bei 23 °C und 50 % relativer Luftfeuchtigkeit nach DIN 53380-Teil 3 gemessen, aufweist.

6. Verfahren nach einem der vorangehenden Ansprüche, **dadurch gekennzeichnet, dass** zunächst die Haftklebemassenschicht, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird.

7. Verfahren nach einem der Ansprüche 1 bis 4, **dadurch gekennzeichnet, dass**
die Haftklebemassenschicht und die Abdeckung gemeinsam auf das Substrat und/oder die elektronische Anordnung aufgebracht werden.

8. Verfahren nach einem der vorangehenden Ansprüche, **dadurch gekennzeichnet, dass**
die Abdeckung die elektronische Anordnung vollständig überdeckt.

9. Verfahren nach Anspruch 8, **dadurch gekennzeichnet, dass**
auch ein Bereich des Substrats um die elektronische Anordnung herum durch die Abdeckung ganz oder teilweise überdeckt wird.

10. Verfahren nach einem der vorangehenden Ansprüche, **dadurch gekennzeichnet, dass** die Klebemassenschicht die elektronische Anordnung vollständig überdeckt.

11. Verfahren nach Anspruch 10, **dadurch gekennzeichnet, dass**
auch ein Bereich des Substrats um die elektronische Anordnung herum ganz oder teilweise durch die Klebemassenschicht überdeckt wird.

12. Klebeband umfassend zumindest eine Schicht einer Klebemasse, wobei die Haftklebemasse ein zur Sorption von Wasser befähigtes Gettermaterial umfasst, wobei das Gettermaterial ausgewählt ist aus Calciumoxid, Calciumsulfat, Calciumchlorid und Zeolithen sowie aus Mischungen von zwei oder mehreren der vorstehenden Substanzen,
**dadurch gekennzeichnet, dass**
die Klebemasse, wenn ausgeformt zur Schicht mit einer Dicke von 50 µm, eine Wasserdampfpermetationsrate von weniger als 50 g/m²d aufweist, wie bei 38 °C und 90 % relativer Luftfeuchtigkeit nach ASTM F-1249 gemessen,
die Klebemasse einen Permeatgehalt von weniger als 1000 ppm wie nach DIN 53715 nach Lagerung über 24 Stunden bei 23 °C und 50 % relativer Luftfeuchte bestimmt enthält, bezogen auf die Relation des enthaltenen Gesamtgewichts an Permeaten zum Klebemassengewicht, wobei das Permeat Wasser ist, und
das Gettermaterial zu einem Anteil von nicht mehr als 2 Gew.-% und mindestens 0,5 Gew.-%, jeweils bezogen auf die Klebemasse mit dem Gettermaterial, in der Klebemasse vorliegt.

13. Verfahren zur Herstellung eines Klebebands nach Anspruch 12, bei dem zunächst ein erstes zur Sorption von Wasser befähigtes Gettermaterial zu der Klebemasse zugegeben wird, und dann ein zweites zur Sorption von Wasser befähigtes Gettermaterial, das ausgewählt ist aus Calciumoxid, Calciumsulfat, Calciumchlorid und Zeolithen sowie aus Mischungen von zwei oder mehreren der vorstehenden Substanzen, zugeben wird, wobei das erste Gettermaterial vor oder nach der Zugabe des zweiten Gettermaterials durch Filtern, Absetzen und Abdekantieren, Fällen, Zentrifugieren oder chemische Umsetzung aus der in fluidem Zustand vorliegenden Masse entfernt wird, und sodann ein Klebeband ausgeformt wird.

14. Verfahren nach Anspruch 13, **dadurch gekennzeichnet, dass** das erste Gettermaterial eine größere Partikelgröße aufweist als das zweite Gettermaterial, insbesondere einen mittleren Durchmesser von mehr als 100 µm, bevorzugt von mehr als 500 µm.

## Claims

1. Method for protecting an electronic arrangement comprising organic constituents that is arranged on a substrate,
where a liner is applied to the electronic arrangement in such a way that the electronic arrangement is at least partly covered by the liner, and
where the liner is bonded at least to a partial area on the substrate and/or on the electronic arrangement, the bond being brought about by means of at least one layer of an adhesive in an adhesive tape,
**characterized in that**
an adhesive is used which, shaped to a layer having a thickness of 50 µm, has a water vapour permeation rate of less than 50 g/m²d, as measured at 38°C and 90% relative atmospheric humidity in accordance with ASTM F-1249,
the adhesive comprises a permeate content of less than 1000 ppm as determined in accordance with DIN 53715 after storage over 24 hours at 23°C and 50% relative atmospheric humidity, based on the relation of the total weight of permeate present to the adhesive weight, the permeate being water, and
the adhesive comprises a getter material capable of sorbing water, the getter material being selected from calcium oxide, calcium sulfate, calcium chloride, and zeolites, and also from mixtures of two or more of the above substances, and the getter material being present in the adhesive at a fraction of not more than 2 wt% and at least 0.5 wt%, based in each case on the adhesive with the getter material.

2. Method according to Claim 1, **characterized in that** the adhesive tape is a single-layer adhesive tape comprising the layer of adhesive.

3. Method according to either of the preceding claims,
**characterized in that**
the fraction of the getter material in the adhesive is not more than 1 wt%.

4. Method according to any of the preceding claims,
**characterized in that**
the getter material is in nanoscale form,
more particularly such that the extent in at least one dimension is not more than 500 nm, preferably not more than 200 nm, very preferably not more than 100 nm.

5. Method according to any of the preceding claims,
**characterized in that**
the adhesive has an oxygen permeation rate of less than 5000 g/m²d bar, as measured at 23°C and 50% relative atmospheric humidity in accordance with DIN 53380-Part 3.

6. Method according to any of the preceding claims,
**characterized in that**
first of all the layer of pressure-sensitive adhesive, optionally as part of a double-sided adhesive tape comprising further layers, and, in a subsequent step, the liner are applied to the substrate and/or the electronic arrangement.

7. Method according to any of Claims 1 to 4,
**characterized in that**
the layer of pressure-sensitive adhesive and the liner are applied jointly to the substrate and/or the electronic arrangement.

8. Method according to any of the preceding claims,
**characterized in that**
the liner completely covers the electronic arrangement.

9. Method according to Claim 8, **characterized in that** a region of the substrate around the electronic arrangement as well is wholly or partly covered by the liner.

10. Method according to any of the preceding claims,
**characterized in that**
the layer of adhesive completely covers the electronic arrangement.

11. Method according to Claim 10, **characterized in that** a region of the substrate around the electronic arrangement as well is wholly or partly covered by the layer of adhesive.

12. Adhesive tape comprising at least one layer of an adhesive, the pressure-sensitive adhesive comprising a getter material capable of sorbing water, the getter material being selected from calcium oxide, calcium sulfate, calcium chloride, and zeolites, and also from mixtures of two or more of the above substances,
**characterized in that**
the adhesive, when shaped to a layer having a thickness of 50 µm, has a water vapour permeation rate of less than 50 g/m²d, as measured at 38°C and 90% relative atmospheric humidity in accordance with ASTM F-1249,
the adhesive comprises a permeate content of less than 1000 ppm as determined in accordance with DIN 53715 after storage over 24 hours at 23°C and 50% relative atmospheric humidity, based on the relation of the total weight of permeate present to the adhesive weight, the permeate being water, and
the getter material being present in the adhesive at a fraction of not more than 2 wt% and at least 0.5 wt%, based in each case on the adhesive with the getter material.

13. Method for producing an adhesive tape according to Claim 12, wherein first of all a first getter material capable of sorbing water is added to the adhesive, and then a second getter material capable of sorbing water is added, selected from calcium oxide, calcium sulfate, calcium chloride, and zeolites, and also from mixtures of two or more of the above substances, the first getter material being removed from the adhesive present in fluid state, before or after the addition of the second getter material, by filtering, settling and decanting, precipitating, centrifuging, or chemical reaction, and then an adhesive tape is shaped.

14. Method according to Claim 13, **characterized in that** the first getter material has a larger particle size than the second getter material, more particularly an average diameter of more than 100 µm, preferably of more than 500 µm.

## Revendications

1. Procédé pour la protection d'un dispositif électronique comprenant des composants organiques et disposé sur un substrat,
une couverture étant appliquée de telle manière sur le dispositif électronique que le dispositif électronique est au moins partiellement recouvert par la couverture, la couverture étant collée au moins partiellement en surface sur le substrat et/ou sur le dispositif électronique, le collage étant effectué au moyen d'au moins une couche d'une masse adhésive dans un ruban adhésif,
**caractérisé en ce qu'**une masse adhésive est utilisée qui, mise sous forme d'une couche dotée d'une épaisseur de 50 µm, présente une vitesse de perméation de vapeur d'eau inférieure à 50 g/m² jour, telle que mesurée à 38 °C et 90 % d'humidité relative de l'air selon la norme ASTM F-1249,
la masse adhésive contient une teneur en perméat inférieure à 1 000 ppm comme déterminée selon la norme DIN 53715 après stockage pendant 24 heures à 23 °C et 50 % d'humidité relative de l'air, par rapport au rapport du poids total contenu de perméat sur le poids de masse adhésive, le perméat étant de l'eau, et
la masse adhésive comprend un matériau getter apte à la sorption d'eau, le matériau getter étant choisi parmi l'oxyde de calcium, le sulfate de calcium, le chlorure de calcium et des zéolithes ainsi que des mélanges de deux ou plus des substances précédentes, et le matériau getter étant présent dans la masse adhésive en une proportion non supérieure à 2 % en poids et d'au moins 0,5 % en poids, à chaque fois par rapport à la masse adhésive avec le matériau getter.

2. Procédé selon la revendication 1, **caractérisé en ce que** le ruban adhésif est un ruban adhésif monocouche de la couche de masse adhésive.

3. Procédé selon l'une quelconque des revendications précédentes, **caractérisé en ce que** la proportion du matériau getter dans la masse adhésive n'est pas supérieure à 1 % en poids.

4. Procédé selon l'une quelconque des revendications précédentes, **caractérisé en ce que** le matériau getter est présent à l'échelle nanométrique,
en particulier de telle manière que l'extension dans au moins une dimension n'est pas supérieure à 500 nm, préférablement n'est pas supérieure à 200 nm, très préférablement n'est pas supérieure à 100 nm.

5. Procédé selon l'une quelconque des revendications précédentes, **caractérisé en ce que** la masse adhésive présente une vitesse de perméation d'oxygène inférieure à 5 000 g/m² jour bar, comme mesurée à 23 °C et 50 % d'humidité relative de l'air selon la norme DIN 53380-partie 3.

6. Procédé selon l'une quelconque des revendications précédentes, **caractérisé en ce que** d'abord la couche de masse autoadhésive, éventuellement en tant que composant d'un ruban adhésif double face comprenant d'autres couches, et, dans une étape ultérieure, la couverture, sont appliquées sur le substrat et/ou le dispositif électronique.

7. Procédé selon l'une quelconque des revendications 1 à 4, **caractérisé en ce que** la couche de masse autoadhésive et la couverture sont appliquées conjointement sur le substrat et/ou le dispositif électronique.

8. Procédé selon l'une quelconque des revendications précédentes, **caractérisé en ce que** la couverture recouvre totalement le dispositif électronique.

9. Procédé selon la revendication 8, **caractérisé en ce qu'**une zone du substrat autour du dispositif électronique est recouverte totalement ou partiellement par la couverture.

10. Procédé selon l'une quelconque des revendications précédentes, **caractérisé en ce que** la couche de masse adhésive recouvre totalement le dispositif électronique.

11. Procédé selon la revendication 10, **caractérisé en ce qu'**une zone du substrat autour du dispositif électronique est recouverte totalement ou partiellement par la couche de masse adhésive.

12. Ruban adhésif comprenant au moins une couche d'une masse adhésive, la masse autoadhésive comprenant un matériau getter apte à la sorption d'eau, le matériau getter étant choisi parmi l'oxyde de calcium, le sulfate de calcium, le chlorure de calcium et des zéolithes ainsi que des mélanges de deux ou plus des substances précédentes,
**caractérisé en ce que**
la masse adhésive, lorsqu'elle est mise sous forme d'une couche dotée d'une épaisseur de 50 µm, présente une vitesse de perméation de vapeur d'eau inférieure à 50 g/m² jour, telle que mesurée à 38 °C et 90 % d'humidité relative de l'air selon la norme ASTM F-1249,
la masse adhésive contient une teneur en perméat inférieure à 1 000 ppm comme déterminée selon la norme DIN 53715 après stockage pendant 24 heures à 23 °C et 50 % d'humidité relative de l'air, par rapport au rapport du poids total contenu de perméat sur le poids de masse adhésive, le perméat étant de l'eau, et
le matériau getter est présent dans la masse adhésive en une proportion non supérieure à 2 % en poids et d'au moins 0,5 % en poids, à chaque fois par rapport à la masse adhésive avec le matériau getter.

13. Procédé pour la préparation d'un ruban adhésif selon la revendication 12, dans lequel tout d'abord un premier matériau getter apte à la sorption d'eau est ajouté à la masse adhésive, et ensuite un deuxième matériau getter apte à la sorption d'eau, qui est choisi parmi l'oxyde de calcium, le sulfate de calcium, le chlorure de calcium et des zéolithes ainsi que des mélanges de deux ou plus des substances précédentes, est ajouté, le premier matériau getter étant éliminé, avant ou après l'ajout du deuxième matériau getter, de la masse se trouvant à l'état fluide par filtration, sédimentation et décantation, précipitation, centrifugation ou transformation chimique, et ensuite un ruban adhésif est formé.

14. Procédé selon la revendication 13, **caractérisé en ce que** le premier matériau getter présente une taille de particule plus grande que le deuxième matériau getter, en particulier un diamètre moyen de plus de 100 µm, préférablement de plus de 500 µm.
